(19) **Europäisches Patentamt / European Patent Office / Office européen des brevets**

(11) **EP 4 782 207 A1**

(12) # EUROPEAN PATENT APPLICATION
published in accordance with Art. 153(4) EPC

(43) Date of publication:
29.07.2026 Bulletin 2026/31

(21) Application number: 25844434.8

(22) Date of filing: 30.06.2025

(51) International Patent Classification (IPC):
*B32B 27/32* (2006.01)   *B32B 9/00* (2006.01)
*B32B 27/34* (2006.01)   *B65D 65/40* (2006.01)
*C23C 14/08* (2006.01)

(52) Cooperative Patent Classification (CPC):
B32B 9/00; B32B 27/32; B32B 27/34; B65D 65/40;
C23C 14/08

(86) International application number:
PCT/JP2025/023436

(87) International publication number:
WO 2026/023339 (29.01.2026 Gazette 2026/05)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH LA MA MD TN

(30) Priority: 23.07.2024  JP 2024118262
23.07.2024  JP 2024118254
02.04.2025  JP 2025061481

(71) Applicant: Dai Nippon Printing Co., Ltd.
Tokyo 162-8001 (JP)

(72) Inventors:
• MIYAZAKI, Yusuke
  Tokyo 162-8001 (JP)
• SHIBATA, Takafumi
  Tokyo 162-8001 (JP)
• MORIMOTO, Taro
  Tokyo 162-8001 (JP)
• TAMADA, Shuhei
  Tokyo 162-8001 (JP)
• YONEDA, Shinya
  Tokyo 162-8001 (JP)
• NISHIDA, Tomoyuki
  Tokyo 162-8001 (JP)

(74) Representative: Müller-Boré & Partner
Patentanwälte PartG mbB
Friedenheimer Brücke 21
80639 München (DE)

(54) **BARRIER FILM, LAMINATE, PACKAGING BAG, AND METHOD FOR MANUFACTURING BARRIER FILM**

(57)    Provided is a barrier film comprising a vapor deposition film formed on an OPP film substrate, the barrier film being capable of lowering barrier properties after heat sterilization treatment and achieving both Gelbo flex resistance and adhesion.

There is provided a barrier film comprising a polypropylene base material provided with a base layer as an outermost layer, and a silicon oxide deposition film formed on the base layer, laminated in this order, wherein the silicon oxide deposition film has an intensity ratio P1 of 0.37 or more and 0.78 or less defined by the following equation when X-ray absorption fine structure analysis is performed from a surface opposite to the polypropylene base material side of the barrier film.

P1 = (maximum intensity value from 1843.8 to 1845.2 eV)/(maximum intensity value from 1847.0 to 1849.4 eV)

# FIG. 1

**Description**

TECHNICAL FIELD

The present invention relates to a barrier film, a laminate, a packaging bag, and a method for producing a barrier film.

BACKGROUND ART

There has hitherto been used a laminated film provided with a film formed on a base material such as a long film or sheet made of plastic or the like in various applications. For example, there has been developed a barrier film provided with a barrier function against oxygen and water vapor by providing a barrier layer composed of a thin film of aluminum oxide or the like on a plastic film.

As a method for producing a barrier film provided with an aluminum oxide thin film, for example, Patent Document 1 discloses a method for producing a barrier film in which the surface of a PET film is subjected to a plasma treatment and then aluminum oxide is deposited.

Meanwhile, in recent years, from the viewpoint of environmental consideration, a mono-material packaging material has been studied for the purpose of improving the recyclability of packaging materials. For example, instead of the polyester film (PET film) which has conventionally been used, a polyolefin film such as a biaxially oriented polypropylene film (OPP film) is used as the base material, and a laminate including a polyolefin film such as a non-oriented polypropylene film (CPP film) as the sealant layer to be laminated with this is being studied as the mono-material packaging material (see Patent Document 2).

Citation List

Patent Documents

Patent Document 1: Japanese Patent No. 7355957
Patent Document 2: Japanese Patent No. 6902231

DISCLOSURE OF THE INVENTION

Problems to be Solved by the Invention

Patent Document 2 discloses a barrier laminate including an OPP film base material, a deposition film, and a barrier coat layer provided on the deposition film, and by controlling the barrier coat layer, it is possible to produce a barrier film having excellent transparency and barrier properties after a boiling treatment or a retort treatment, even when using the OPP film base material.

However, in addition to this, the resistance to the flexion test (Gelbo flex test) and adhesion also have been required, and further improvements have been needed to obtain the above physical properties without providing a barrier coat layer which requires high equipment costs.

Means for Solving the Problems

The present inventors have intensively studied to solve the above problems and found a barrier film which has not only excellent barrier properties after a boiling treatment or a retort treatment, but also excellent resistance to the Gelbo Flex test and adhesion, when using an OPP film base material or even when providing no barrier coat layer, leading to the completion of the present invention. Specifically, the present invention provides the following.

(1) A barrier film comprising a polypropylene base material provided with a base layer as an outermost layer, and a silicon oxide deposition film formed on the base layer, laminated in this order, wherein
the silicon oxide deposition film has an intensity ratio P1 of 0.37 or more and 0.78 or less defined by the following equation when X-ray absorption fine structure analysis is performed from a surface opposite to the polypropylene base material side of the barrier film,

3

P1 = (maximum intensity value from 1843.8 to 1845.2 eV)/(maximum intensity value from 1847.0 to 1849.4 eV).

(2) A barrier film comprising a polypropylene base material provided with a base layer as an outermost layer, and a silicon oxide deposition film formed on the base layer, laminated in this order, wherein
the silicon oxide deposition film has an intensity ratio P2 of 0.45 or more and 0.88 or less defined by the following equation when X-ray absorption fine structure analysis is performed from a surface opposite to the polypropylene base material side of the barrier film, P2 = (maximum intensity value from 1845.4 to 1846.4 eV)/(maximum intensity value from 1847.0 to 1849.4 eV).

(3) The barrier film according to claim 1 or 2, wherein the base layer comprises a polyamide resin.
(4) The barrier film according to (1) or (2), wherein the polypropylene base material comprises at least the base layer and a first layer in this order, and
the first layer contains homopolypropylene.
(5) The barrier film according to (1) or (2), wherein the polypropylene base material comprises at least the base layer, a first layer and a second layer in this order,

the first layer contains modified polypropylene, and
the second layer contains homopolypropylene.

(6) The barrier film according to (5), wherein the polypropylene base material comprises at least the base layer, a first layer, a second layer, and a third layer in this order,
the first layer contains modified polypropylene,

the second layer contains homopolypropylene, and
the third layer contains a copolymer of propylene and olefin other than propylene.

(7) The barrier film according to (3), including, as the polyamide resin, an amorphous aromatic polyamide alone, or a mixture of 50% by mass or more and less than 100% by mass of an amorphous aromatic polyamide and more than 0% by mass and less than 50% by mass of a crystalline aromatic polyamide.
(8) The barrier film according to (1) or (2), wherein a covering layer is laminated on the silicon oxide deposition film.
(9) A laminate including the barrier film according to any one of (1) or (2) and a sealant layer.
(10) A packaging bag including the laminate according to (9).
(11) A method for producing a barrier film including a polypropylene base material provided with a base layer as an outermost layer, and a silicon oxide deposition film formed on the base layer, laminated in this order, wherein

the silicon oxide deposition film has an intensity ratio P1 of 0.37 or more and 0.78 or less, or P2 of 0.45 or more and 0.88 or less defined by the following equation when X-ray absorption fine structure analysis is performed from a surface opposite to the polypropylene base material side of the barrier film, and
wherein the silicon oxide deposition film is a deposition film formed by physical vapor deposition (PVD), P1 = (maximum intensity value from 1843.8 to 1845.2 eV)/(maximum intensity value from 1847.0 to 1849.4 eV) P2 = (maximum intensity value from 1845.4 to 1846.4 eV)/(maximum intensity value from 1847.0 to 1849.4 eV).

Effects of the Invention

The barrier film of the present invention has not only excellent barrier properties after a heat sterilization treatment such as a boiling treatment or a retort treatment, but also excellent resistance to the Gelbo Flex test and adhesion, when using an OPP film base material or even when providing no barrier coat layer.

BRIEF DESCRIPTION OF THE DRAWINGS

FIG. 1 is a cross-sectional view illustrating an example of the barrier film according to the present embodiment;

FIG. 2 is a cross-sectional view illustrating an example of the laminate including the barrier film of the present invention;

FIG. 3 is a cross-sectional view illustrating another example of the laminate including the barrier film of the present invention;

FIG. 4 is a graph illustrating superimposed XAFS spectra after the normalization in Examples and Comparative Examples;

FIG. 5 is a graph showing an XAFS spectrum after the normalization of the barrier film of Example 1;

FIG. 6 is a graph showing an XAFS spectrum after the normalization of the barrier film of Example 3;

FIG. 7 is a graph showing an XAFS spectrum after the normalization of the barrier film of Example 7;

FIG. 8 is a graph showing an XAFS spectrum after the normalization of the barrier film of Example 8;

FIG. 9 is a graph showing an XAFS spectrum after the normalization of the barrier film of Example 9;

FIG. 10 is a graph showing an XAFS spectrum after the normalization of the barrier film of Example 10.

FIG. 11 is a graph showing an XAFS spectrum after the normalization of the barrier film of Comparative Example 1; and

FIG. 12 is a graph showing an XAFS spectrum after the normalization of the barrier film of Comparative Example 3.

PREFERRED MODE FOR CARRYING OUT THE INVENTION

Specific embodiments of the present invention will be described in detail below, but the present invention is not limited to the following embodiments in any way and can be implemented with appropriate modifications within the scope of the purpose of the present invention. As used herein, the notation "X to Y" (X and Y are arbitrary numbers) means "X or more and Y or less".

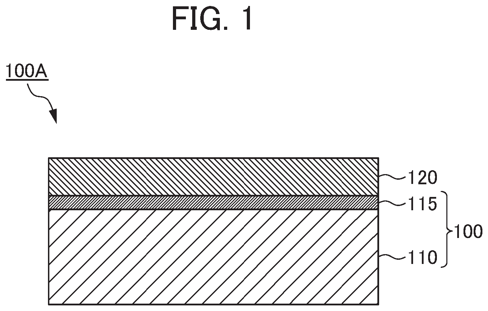

FIG. 1 is a cross-sectional view illustrating an example of the barrier film according to the present embodiment. A barrier film 100A of the present embodiment includes a base material 100 corresponding to the polypropylene base material of the present invention, and a deposition film 120. The base material 100 is composed of at least two layers including a polypropylene layer 110 and a base layer 115. If necessary, a covering layer 130 (not shown) may be provided on the deposition film 120. In the example shown in FIG. 1, a base layer 115 is located on one surface of the polypropylene layer 110. In the example shown in FIG. 1, the barrier film 100A is composed of the polypropylene layer 110, the base layer 115, and the deposition film 120 laminated sequentially, and the deposition film 120 is located on the surface of the barrier film. The deposition film 120 constitutes a barrier layer. When the covering layer 130 is provided, the deposition film 120 and the covering layer 130 constitute a barrier layer.

As used herein, "lamination in this order" means that a polypropylene base material, a base layer, and a silicon oxide deposition film are laminated merely in this order, and layers such as an anchor coat layer mentioned later may be further laminated between these layers.

Each layer constituting the barrier film 100A will be described below.

[Polypropylene Layer]

The polypropylene layer 110 is composed of at least polypropylene. The polypropylene may be any of a propylene homopolymer, a propylene random copolymer, and a propylene block copolymer, or may be a mixture of two or more selected from these.

The propylene homopolymer is a polymer made of only propylene. The propylene random copolymer is a random copolymer of propylene and an $\alpha$-olefin other than propylene or the like. The propylene block copolymer is a copolymer including a polymer block made of propylene and a polymer block made of at least an $\alpha$-olefin other than propylene or the like. The latter polymer block may be a polymer block composed of propylene and an $\alpha$-olefin other than propylene.

Examples of the $\alpha$-olefin include $\alpha$-olefins having 2 or more and 20 or less carbon atoms, and specific examples thereof include ethylene, 1-butene, 1-pentene, 1-hexene, 1-octene, 1-decene, 1-dodecene, 1-tetradecene, 1-hexadecene, 1-octadecene, 1-eicosene, 3-methyl-1-butene, 4-methyl-1-pentene, and 6-methyl-1-heptene.

Among polypropylenes, it is preferable to use a random copolymer from the viewpoint of transparency. When emphasis is placed on the rigidity and heat resistance of the laminate, it is preferable to use a homopolymer. When emphasis is placed on the impact resistance of the laminate, it is preferable to use a block copolymer.

In one embodiment, the melt flow rate (MFR) of the polypropylene may be 0.1 g/10 min or more and 50 g/10 min or less, or 0.3 g/10 min or more and 30 g/10 min or less, from the viewpoints of the film-forming properties and processability. The lower limit of the melt flow rate (MFR) of the polypropylene may be 0.1 g/10 min or more, or 0.3 g/10 min or more. The upper limit of the melt flow rate (MFR) of the polypropylene may be 50 g/10 min or less, or 30 g/10 min or less. MFR of the polypropylene is measured in accordance with ASTM D1238 under the conditions of a temperature of 230°C and a load of 2.16 kg.

As the polypropylene, biomass-derived polypropylene, or mechanically recycled or chemically recycled polypropylene may be used.

The polypropylene content in the polypropylene layer 110 is preferably 70% by mass or more, more preferably 80% by mass or more, still more preferably 90% by mass or more, and yet more preferably 95% by mass or more.

The polypropylene layer 110 may contain a resin material other than the polypropylene. Examples of the resin material include polyolefins such as polyethylene, (meth)acrylic resins, vinyl resins, cellulose resins, polyamides, polyesters, and ionomer resins.

The polypropylene layer 110 may contain additives. Examples of the additives include crosslinking agents, antioxidants, antiblocking agents, slip agents, ultraviolet absorbers, light stabilizers, fillers, reinforcing agents, lubricants, antistatic agents, pigments, and modifying resins.

The polypropylene layer 110 may be a multi-layer film including at least a first layer and a second layer. The first layer is a layer on one side of the polypropylene base material (the side on which a barrier layer such as a deposition film is formed), and the second layer is a layer on the other side of the polypropylene base material.

The first layer and the second layer each may be a propylene random copolymer which is a random copolymer of propylene and an $\alpha$-olefin other than propylene or the like. When the first layer and the second layer are made of the random copolymer, it is possible to improve the adhesion between the layers and other layers in contact with the layers. Examples of the $\alpha$-olefin include ethylene, 1-butene, 1-hexene and the like.

The first layer may be a modified polypropylene, such as an acid modified polypropylene having polar groups such as maleic acid, exemplified by ADMER (a registered trademark). When the base layer mentioned later is made of a polyamide resin, the adhesion to the polyamide resin is improved.

The polypropylene layer 110 may include a third layer as an intermediate layer between the first layer and the second layer. The intermediate layer preferably contains a homopolymer of polypropylene. The intermediate layer may have a single-layer structure or a multi-layer structure.

(Example of Layer Structure of Barrier Film)

An example of a specific layer structure of the barrier film 100A including a single polypropylene layer 110 is deposition film/base layer/propylene homopolymer (first layer), from the side on which the deposition film is formed.

Another example of a specific layer structure of the barrier film 100A including two polypropylene layers 110 is deposition film/base layer/modified polypropylene (first layer)/propylene homopolymer (second layer), from the side on which the deposition film is formed.

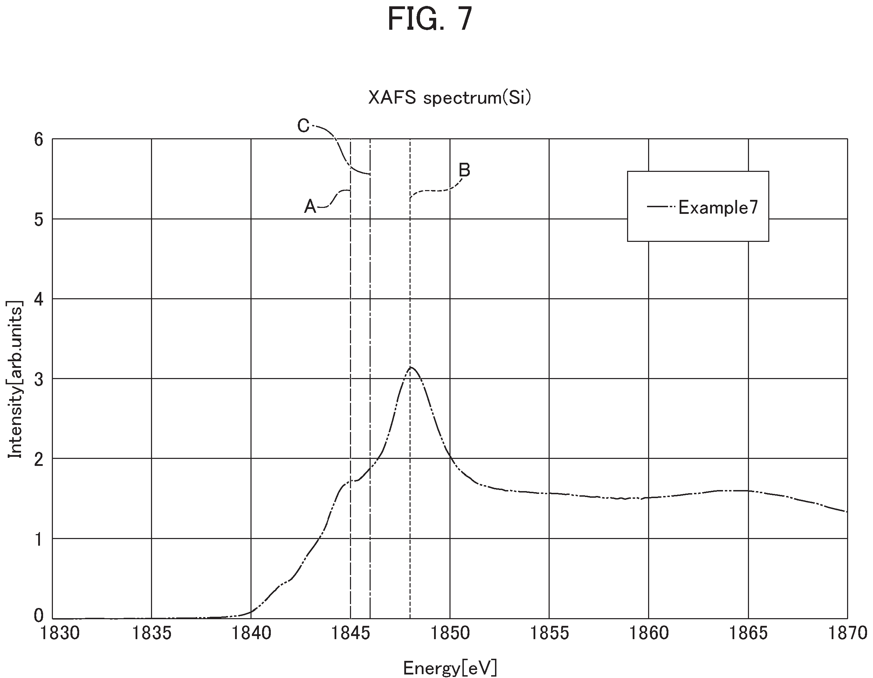

Another example of a specific layer structure of the barrier film 100A including three polypropylene layers 110 is deposition film/base layer/propylene random copolymer (first layer)/propylene homopolymer (third layer)/propylene random copolymer (second layer), from the side on which the deposition film is formed. In this case, when the first layer is a propylene random copolymer and the base layer mentioned later is an anchor coat layer, the adhesion to the anchor coat layer is improved. Since the second layer is a propylene random copolymer, the adhesion to the first adhesive layer 161 for laminating a sealant layer 150 is improved, for example, when forming the laminate shown in FIG. 7 mentioned later.

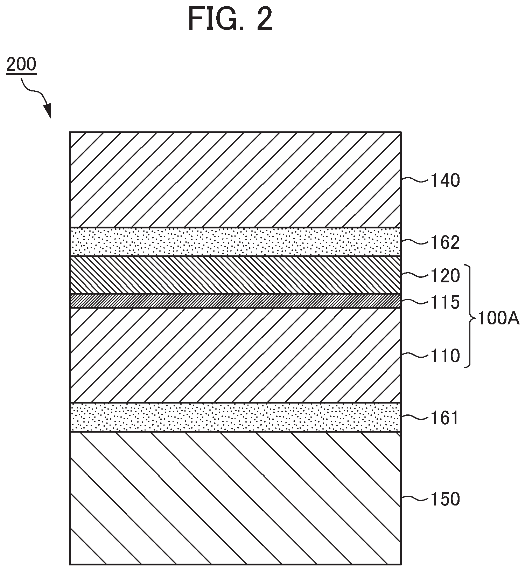

Another example of a specific layer structure of the barrier film 100A including three polypropylene layers 110 is deposition film/base layer/modified polypropylene (first layer)/propylene homopolymer (third layer)/propylene random copolymer (second layer), from the side on which the deposition film is formed. In this case, when the first layer is made of modified polypropylene, the below-mentioned adhesion to the polyamide resin of the base layer is improved. Since the third layer is made of a propylene random copolymer, the adhesion to the first adhesive layer 161 for laminating the sealant layer 150 is improved, for example, when forming the laminate shown in FIG. 2 mentioned later.

[Base layer]

The base layer 150 is formed on the surface of the base material 100 on which the deposition film 120 is formed. When the base layer is a highly heat-resistant surface resin layer made of a high-melting point resin material or a material with a high glass transition point, as mentioned later, the improved vapor deposition resistance promotes migration of the vapor deposition material, resulting in a deposition film made of a dense, continuous layer with few gaps and excellent flexibility. Since the base layer is made of a highly heat-resistant material, the resistance to a heat sterilization treatment is also improved. When the base layer is an anchor coat layer formed by coating mentioned later, the surface of the base material can be made smoother, promoting migration of the vapor deposition material and increasing the adhesive strength between the polypropylene base material and the deposition film, thus obtaining a deposition film composed of a dense, continuous layer with few gaps and excellent flexibility. These properties make it possible to obtain high gas barrier properties, and also to prevent the breakage of the deposition film and the covering layer due to deformation or bending of the film, and the resulting deterioration of the gas barrier properties. Thus, it is possible to obtain a barrier film having excellent heat resistance that can withstand the heat sterilization treatment.

When the base layer is a surface resin layer, the surface resin layer contains a polyamide resin. The polyamide resin is a resin material having a melting point of 180°C or higher or a glass transition point of 90°C or higher, and having polar groups. Specifically, polyamides such as nylon 6 (hereinafter "nylon" is a registered trademark), nylon 6,6, aromatic-containing nylon, and amorphous nylon (amorphous polyamide) are more preferred. By using such a resin material, the gas barrier properties of the deposition film formed on the surface resin layer can be effectively improved.

By using polyamide as a highly heat-resistant material, it is possible to suppress deterioration of the gas barrier properties even when the barrier laminate is heated. As the highly heat-resistant material, polyamide containing a benzene ring (aromaticity) is preferred from the viewpoint of the mechanical strength and gas barrier properties. The polyamide containing a benzene ring can be used in combination with other materials and co-extruded. Examples of the polyamide containing a benzene ring include nylon MXD6 manufactured by Mitsubishi Gas Chemical Company, Inc. and the like.

The polyamide containing a benzene ring is a polyamide containing a benzene ring in either or both of structural units derived from diamine or dicarboxylic acid. It may also be a copolymer of one or more diamines and one or more dicarboxylic acids. A mixture of two or more copolymers may also be used. Examples of the copolymer include a copolymer of a diamine containing a benzene ring and an aliphatic dicarboxylic acid, a copolymer of an aliphatic diamine and a dicarboxylic acid containing a benzene ring, a copolymer of a diamine containing a benzene ring, a dicarboxylic acid containing a benzene ring and an aliphatic dicarboxylic acid, and a copolymer of an aliphatic diamine, a diamine containing a benzene ring and a dicarboxylic acid containing a benzene ring.

The surface resin layer may contain a polyamide which does not contain a benzene ring. Polyester, an acrylic resin, an ionomer resin and the like may be added to the extent that they do not affect the processability and physical properties.

Examples of the diamine containing a benzene ring include metaxylenediamine, paraxylenediamine, metaphenylenediamine, paraphenylenediamine and the like. One or more of them are used.

Examples of the dicarboxylic acid containing a benzene ring include aromatic dicarboxylic acids such as terephthalic acid (TPA) and isophthalic acid (IPA); and naphthalenedicarboxylic acids such as 1,2-naphthalenedicarboxylic acid, 1,3-naphthalenedicarboxylic acid, 1,4-naphthalenedicarboxylic acid, 1,5-naphthalenedicarboxylic acid, 1,6-naphthalenedicarboxylic acid, 1,7-naphthalenedicarboxylic acid, 1,8-naphthalenedicarboxylic acid, 2,3-naphthalenedicarboxylic acid, 2,6-naphthalenedicarboxylic acid, and 2,7-naphthalenedicarboxylic acid. One or more of them are used.

Examples of the aliphatic diamine include linear aliphatic diamines such as 1,4-butanediamine, 1,5-pentanediamine, 1,6-hexanediamine (hexamethylenediamine), 1,7-heptanediamine, 1,8-octanediamine, 1,9-nonanediamine (NDA), 1,10-decanediamine (DDA), 1,11-undecanediamine, and 1,12-dodecanediamine; branched aliphatic diamines such as 2-methyl-1,8-octanediamine (MODA), 4-methyl-1,8-octanediamine, 5-methyl-1,9-nonanediamine, 2,2,4-/2,4,4-trimethyl-1,6-hexanediamine, 2-methyl-1,5-pentanediamine, 2-methyl-1,6-hexanediamine, and 2-methyl-1,7-heptanediamine; and alicyclic diamines such as isophoronediamine, norbornanedimethylamine, and tricyclodecanedimethylamine. One or more of them are used.

The aliphatic dicarboxylic acid is an aliphatic dicarboxylic acid having 2 to 20 carbon atoms. In consideration of the polymerization suitability and processability, adipic acid is most preferred, but examples of other dicarboxylic acids include oxalic acid, malonic acid, succinic acid, glutaric acid, pimelic acid, suberic acid, azelaic acid, sebacic acid, undecanedioic acid, dodecadioic acid, hexadecadioic acid, eicosanedioic acid, eicosadienedioic acid, and 2,2,4-trimethyladipic acid. One or more of them are used.

Examples of the polyamide containing no benzene ring include polyamides 6, 7, 10, 11, 12, 410, 56, 66, 69, 610, 611, 612, 1010 and the like. The surface resin layer may contain one or more of them.

The surface resin layer preferably contains 20% by mass or more, more preferably 40% by mass or more, still more preferably 60% by mass or more, and yet more preferably 80% by mass or more, of the polyamide containing a benzene ring relative to the entire surface resin layer. By containing 20% by mass or more of the polyamide containing a benzene ring, since hydrothermal swelling can be suppressed, it is possible to improve the adhesion to the deposition film and reduce deterioration of the barrier performance of the deposition film during heat sterilization by boiling or retorting. When the content is less than 20% by mass, the adhesion to the deposition film may be poor and the barrier may be reduced during heat sterilization.

The surface resin layer preferably contains 20% by mass or more, more preferably 30% by mass or more, and still more preferably 40% by mass or more, of a crystalline polyamide. By including 20% by mass or more of the crystalline polyamide, gas barrier properties can be improved and hydrothermal swelling can be suppressed. Examples of the crystalline polyamide include a copolymer of metaxylenediamine and adipic acid, a copolymer of hexamethylenediamine and terephthalic acid, polyamide 6 and the like.

The surface resin layer preferably contains 90% by mass or less, more preferably 80% by mass or less, and still more preferably 70% by mass or less, of the crystalline polyamide. This allows an amorphous polyamide mentioned later to be mixed.

The surface resin layer preferably contains 25% by mass or more, more preferably 30% by mass or more, and still more preferably 40% by mass or more, of the amorphous polyamide. By including 25% by mass or more of the amorphous polyamide, the extrusion suitability and stretchability are improved, thus making it easier to produce the base film 10. Examples of the amorphous polyamide include a copolymer of hexamethylenediamine and isophthalic acid, a copolymer of metaxylenediamine and isophthalic acid, a copolymer of hexamethylenediamine and dicarboxylic acid in which a molar ratio of isophthalic acid/terephthalic acid is 7/3, and a copolymer of metaxylenediamine and a dicarboxylic acid in which a molar ratio of adipic acid/isophthalic acid is 1/1.

The surface resin layer preferably contains 100% by mass or less, more preferably 80% by mass or less, still more preferably 70% by mass or less, and yet more preferably 60% by mass or less, of the amorphous polyamide. This allows the crystalline polyamide to be mixed.

The surface resin layer is preferably made of an amorphous aromatic polyamide alone, or a mixture of 50% by mass or more and less than 100% by mass of an amorphous aromatic polyamide and more than 0% by mass and less than 50% by mass of a crystalline aromatic polyamide. This improves the oxygen barrier properties after high retort treatment. More specifically, it is preferable because the oxygen transmission rate after high retort treatment mentioned later becomes 1.0 cc/m$^2$·day or less.

The thickness of the surface resin layer is preferably more than 0.1 $\mu$m and less than 5 $\mu$m, more preferably 0.3 $\mu$m or more and 2 $\mu$m or less, still more preferably 0.4 $\mu$m or more and 1.5 $\mu$m or less, and particularly preferably 0.6 $\mu$m or more and 1 $\mu$m or less. The lower limit of the thickness of the surface resin layer is preferably more than 0.1 $\mu$m, more preferably 0.3 $\mu$m or more, still more preferably 0.4 $\mu$m or more, and particularly preferably 0.6 $\mu$m or more. The upper limit of the thickness of the surface resin layer is preferably less than 5 $\mu$m, more preferably 2 $\mu$m or less, still more preferably 1.5 $\mu$m or less, and particularly preferably 1 $\mu$m or less. When the thickness is 0.1 $\mu$m or less, it is difficult to form a film, and when the thickness is 5 $\mu$m or more, curling is likely to occur. By making the thickness of the surface resin layer more than 0.1 $\mu$m, the density of the deposition film can be further improved, and the gas barrier properties can be further improved. By making the thickness less than 5 $\mu$m, the film-forming properties and processability can be further improved.

[Base Material]

The surface resin layer can be formed by melt extrusion. The polypropylene base material of the present invention may be formed by extrusion molding onto a biaxially oriented polypropylene film, or may be formed by multilayer coextrusion with polypropylene, followed by orientation.

The base material 100 corresponding to the polypropylene base material of the present invention is composed of two or more layers including a polypropylene layer 110 and a base layer 115, and can be biaxially oriented as a whole. This can improve, for example, the heat resistance, impact resistance, water resistance and dimensional stability of the barrier base material. A laminate including such a barrier base material is suitable as a packaging material which is subjected to, for example, a boiling treatment or a retort treatment.

When orientation is performed in the machine direction (machine direction, MD direction of the base material), the orientation ratio is preferably 2 times or more and 15 times or less, and more preferably 5 times or more and 13 times or less. When orientation is performed in the machine direction (machine direction, MD direction of the base material), the lower limit of the orientation ratio is preferably 2 times or more, and more preferably 5 times or more. When orientation is performed in the machine direction (machine direction, MD direction of the base material), the orientation ratio is preferably 2 times or more and 15 times or less, and more preferably 5 times or more and 13 times or less. When orientation is performed in the machine direction (machine direction, MD direction of the base material), the lower limit of the orientation ratio is preferably 2 times or more, and more preferably 5 times or more. When orientation is performed in the machine direction (machine direction, MD direction of the base material), the upper limit of the orientation ratio is preferably 15 times or less, and more preferably 13 times or less. When orientation is performed in the transverse direction (direction perpendicular to the MD direction, TD direction), the orientation ratio is preferably 2 times or more and 15 times or less, and more preferably 5 times or more and 13 times or less. When orientation is performed in the transverse direction (direction perpendicular to the MD direction, TD direction), the lower limit of the orientation ratio is preferably 2 times or more, and more preferably 5 times or more. When orientation is performed in the transverse direction (direction perpendicular to the MD direction, TD direction), the upper limit of the orientation ratio is preferably 15 times or less, and more preferably 13 times or less. By setting the orientation ratio at 2 times or more, the strength and heat resistance of the polypropylene layer can be further improved, and when the polypropylene layer is used as the outermost layer, the printability of the polypropylene layer can be improved. From the viewpoint of the breaking limit of the polypropylene layer, the orientation ratio is preferably 15 times or less.

The thickness of the base material 100 is preferably 10 $\mu$m or more and 100 $\mu$m or less, more preferably 10 $\mu$m or more and 50 $\mu$m or less, and still more preferably 15 $\mu$m or more and 25 $\mu$m or less. The lower limit of the thickness of the base material 100 is preferably 10 $\mu$m or more, and more preferably 15 $\mu$m or more. The upper limit of the thickness of the base material 100 is preferably 100 $\mu$m or less, more preferably 50 $\mu$m or less, and still more preferably 25 $\mu$m or less. When the thickness is the lower limit or more, for example, the strength and heat resistance of the barrier base material can be further improved. When the thickness is the upper limit or less, for example, the processability of the barrier base material can be further improved.

The base material 100 may be a coextruded oriented film. The film can be produced by forming a laminated film using a conventionally known T-die method or inflation method, and then orienting the laminated film. When forming the film by the inflation method, the laminated film may be oriented at the same time.

The base material 100 may be subjected to a surface treatment. For example, this can improve the adhesion to other layers. Examples of the surface treatment method include physical treatments such as a corona discharge treatment, an ozone treatment, a low-temperature plasma treatment using one or more gases selected from oxygen gas, argon gas, nitrogen gas and the like, and a glow discharge treatment; and chemical treatments such as an oxidation treatment using chemicals. An easy adhesion layer may be provided on the surface of the base material.

When the base material 100 is used as the outermost layer of the laminate, it may have a printing layer on the second layer. The image formed on the printing layer is not particularly limited, and examples thereof include letters, patterns, symbols, and combinations thereof. The printing layer can also be formed using biomass-derived ink. This further reduces the environmental impact.

Examples of methods for forming a printing layer include conventionally known printing methods such as a gravure printing method, an offset printing method, and a flexographic printing method. Among them, the flexographic printing method is preferred from the viewpoint of reducing the environmental impact.

The base material 100 is preferably transparent. Specifically, it is preferable that the base material has a high total light transmittance measured in accordance with JIS K 7361-1:1997. Specifically, the total light transmittance is preferably 70% or more, more preferably 80% or more, and particularly preferably 90% or more.

In the present invention, the base layer containing a polyamide resin may be an anchor coat layer. The thickness of the anchor coat layer is preferably 0.02 $\mu$m or more and 5 $\mu$m or less, more preferably 0.05 $\mu$m or more and 2 $\mu$m or less, still more preferably 0.1 $\mu$m or more and 1 $\mu$m or less, and still more preferably 0.2 $\mu$m or more and 0.5 $\mu$m or less. The lower limit of the thickness of the anchor coat layer is preferably 0.02 $\mu$m or more, more preferably 0.05 $\mu$m or more, still more preferably 0.1 $\mu$m or more, and yet more preferably 0.2 $\mu$m or more. The upper limit of the thickness of the anchor coat layer is preferably 5 $\mu$m or less, more preferably 2 $\mu$m or less, still more preferably 1 $\mu$m or less, and yet more preferably 0.5 $\mu$m or less. By setting the thickness of the anchor coat layer at 0.02 $\mu$m or more, the smoothness can be further improved, and the gas barrier properties after vapor deposition can be further improved. By setting the thickness of the anchor coat layer at 5 $\mu$m or less, the processability and productivity can be further improved.

The anchor coat layer may be formed by coating (applying, coating) on a biaxially oriented polypropylene base material, or may be formed by coating on a polypropylene film, followed by biaxial orientation.

[Deposition Film]

Next, the deposition film 120 will be described. The deposition film contains silicon oxide which is an inorganic oxide. Silicon oxide is represented by SiOx. The deposition film may further contain metal oxides such as aluminum oxide, silicon nitride, silicon oxynitride, silicon carbide, magnesium oxide, titanium oxide, tin oxide, indium oxide, zinc oxide, and zirconium oxide, or nitrides or carbides of these metals, as long as the effects of the present invention are not impaired. For example, a mixture of silicon oxide (SiO) and silicon dioxide ($SiO_2$) may be used as the deposition material, and in this case, the silicon oxide (SiO) content is preferably 50% by mass or more, and more preferably 60% by mass or more. This improves the water vapor barrier properties after high retort treatment. More specifically, it is preferable because the water vapor transmittance after high retort treatment mentioned later becomes 1.0 cc/m$^2$·day or less.

The thickness of the deposition film is preferably 10 nm or more and 150 nm or less, more preferably 20 nm or more and 100 nm or less, and still more preferably 30 nm or more and 70 nm or less. The lower limit of the thickness of the deposition film is preferably 10 nm or more, more preferably 20 nm or more, and still more preferably 30 nm or more. The upper limit is preferably 150 nm or less, more preferably 100 nm or less, and particularly preferably 70 nm or less.

The deposition film 120 can be formed using a conventionally known method. Examples of the method for forming a deposition film include physical vapor deposition methods (PVD methods) such as a vacuum deposition method, a sputtering method, and an ion plating method; and chemical vapor deposition methods (CVD methods) such as a plasma chemical vapor deposition method, a thermal chemical vapor deposition method, and a photochemical vapor deposition method. Among them, the vacuum deposition method, which is a PVD method, is preferred. This improves the water vapor barrier properties after high retort treatment. More specifically, the water vapor transmittance after high retort treatment mentioned later becomes 1.0 cc/m$^2$·day or less. When using the CVD method, carbon atoms (C) in the raw materials enter the deposition film, which makes it easier to cause deterioration of the barrier properties, particularly the water vapor transmittance.

The deposition film 120 may be a single layer formed by one deposition process, or may be a multi-layer formed by multiple deposition processes. In the case of the multi-layer, each layer may be made of the same material or different materials. Each layer may be formed by the same method or by different methods.

The deposition film 120 may be formed, and a layer containing an organic substance, such as a covering layer 130 mentioned later, may be provided on the outer surface of the deposition film 120. This makes it possible to obtain high barrier properties. A deposition film may be provided on the surface of the layer containing an organic substance, and another layer containing an organic substance may be provided on the outer surface of the deposition film, thereby repeatedly laminating a deposition film and a layer containing an organic substance.

A plasma-assisted vacuum film-forming apparatus can be used as an apparatus for forming a deposition film by the PVD method. Details of this formation method are disclosed in Japanese Unexamined Patent Application Publication No. 2011-214089.

It is possible to use, as the apparatus used in the method for forming a deposition film 120, a continuous deposition film-forming apparatus equipped with a plasma pretreatment chamber and a film-forming chamber. In the plasma pretreatment chamber, plasma is irradiated onto the base layer 115 of the base material 100 from a plasma supply nozzle. Next, in the film-forming chamber, a deposition film 120 is formed on the plasma-treated base layer 115. Details of this forming method are disclosed in PCT International Publication No. WO 2019/087960.

The surface of the deposition film 120 may be subjected to plasma treatment. This improves the adhesion when a covering layer 130 is provided on the surface of the deposition film 120 mentioned later.

(XAFS Spectral Analysis)

XAFS analysis obtains an X-ray absorption fine structure (XAFS) spectrum by irradiating X-rays from the surface side of the deposition surface of the barrier film (when a covering layer is present, from the covering layer side) and measuring the amount of absorption. The details of the measurement conditions and analysis conditions will be mentioned in Examples.

In particular, the XAFS spectral analysis with soft X-rays using synchrotron radiation can obtain bulk information on the entire deposition film, not partial information on the deposition film surface side, and can obtain information on the size of oxygen and carbon in the silicon oxide deposition film. When a covering layer containing no silicon atoms is present on the surface of the deposition film, it is possible to obtain information on the deposition film with the covering layer present by irradiating the deposition film from the covering layer surface side through the covering layer. The measurement may be performed from the surface side of the silicon oxide deposition film before forming the covering film.

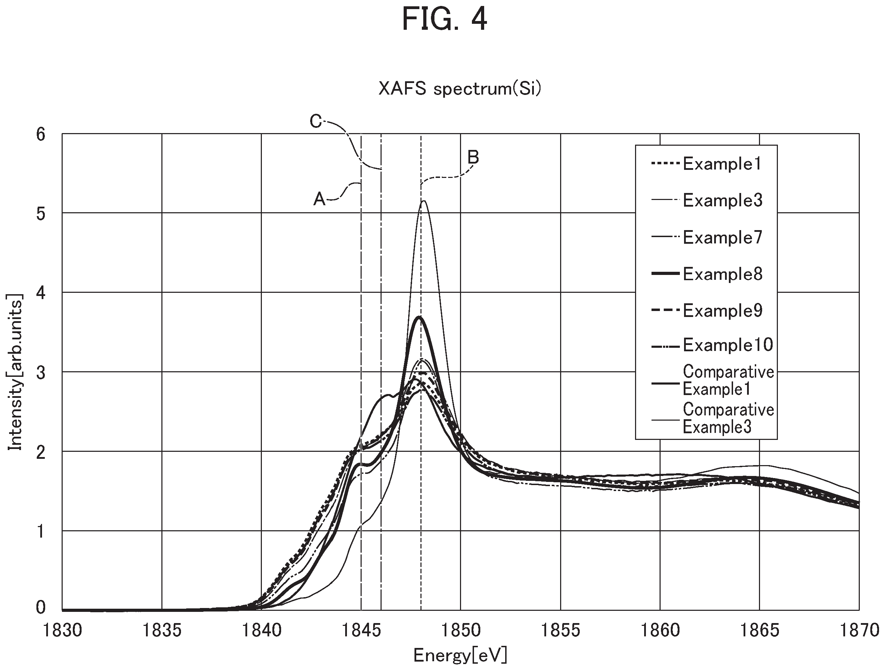

FIG. 4 shows the normalized results of XAFS measurement of the barrier films in Examples and Comparative Examples mentioned later. In FIG. 4, the vertical axis represents absorption intensity (a.u.), and the horizontal axis represents energy (eV).

The barrier film of the present invention is a barrier film having an intensity ratio P1 defined below of 0.37 or more and 0.78 or less. P1 = (maximum intensity value from 1843.8 to 1845.2 eV)/(maximum intensity value from 1847.0 to 1849.4 eV)

Here, the numerator (maximum intensity value from 1843.8 to 1845.2 eV) is the intensity derived from intermediate oxide of silicon oxide (SiOx, x<2) (A in FIG. 4, the same applies to the following figures), and the denominator (maximum intensity value from 1847.0 to 1849.4 eV) is the intensity derived from high oxide of silicon oxide (SiOx, x=2) (B in FIG. 4, the same applies to the following figures). Therefore, the intensity ratio P1 is a value which reflects the degree of oxidation of silicon oxide.

The intensity ratio P1 is preferably 0.37 or more and 0.78 or less, more preferably 0.40 or more and 0.76 or less, and still more preferably 0.50 or more and 0.74 or less. The lower limit of the intensity ratio P1 is preferably 0.37 or more, more preferably 0.40 or more, and still more preferably 0.50 or more. The upper limit of the intensity ratio P1 is preferably 0.78 or less, more preferably 0.76 or less, and still more preferably 0.74 or less.

It is not preferred that the intensity ratio P1 is less than 0.37 because of poor barrier property of the barrier film alone, and it is not preferred that the intensity ratio exceeds 0.78 because of poor barrier properties after high retort treatment.

The intensity ratio P1 in the barrier film can be adjusted by the composition of the material used for silica deposition, or an aging treatment after the film-forming process.

In the barrier film of the present invention, the intensity ratio P2 defined below is preferably 0.45 or more and 0.88 or less. The lower limit of the intensity ratio P2 defined below is preferably 0.45 or more. The upper limit of the intensity ratio P2 defined below is preferably 0.88. P2 = (maximum intensity value from 1845.4 to 1846.4 eV)/(maximum intensity value from 1847.0 to 1849.4 eV)

Here, the numerator (maximum intensity value from 1845.4 to 1846.4 eV) is the intensity derived from SiC (C in FIG. 4, the same applies to the following figures), and the denominator (maximum intensity value from 1847.0 to 1849.4 eV) is the intensity derived from high oxide of silicon oxide (SiOx, x = 2) (B in FIG. 4, the same applies to the following figures). Therefore, the intensity ratio P2 is a value which reflects the amount of SiC present.

The intensity ratio P2 is preferably 0.45 or more and 0.88 or less, and more preferably 0.49 or more and 0.83 or less. The lower limit of the intensity ratio P2 is preferably 0.45 or more, and more preferably 0.49 or more. The upper limit of the intensity ratio P2 is preferably 0.88 or less, and more preferably 0.83 or less.

It is not preferred that the intensity ratio P2 is less than 0.45 because of poor barrier property of the barrier film alone, and it is not preferred that the intensity ratio exceeds 0.88 because of poor barrier properties after high retort treatment.

It is considered that an amorphous silicon oxide film has better flexibility than a crystalline film, and therefore the amorphous silicon oxide film is preferred for use as the barrier film. However, it was difficult to determine whether it is crystalline or amorphous using XRD, which is a conventional X-ray analysis, except in a case where a clear crystalline peak can be confirmed.

It is known that in case of an XAFS spectrum of crystalline silicon oxide, sharp absorptions are observed at 1852.5 eV, 1856.0 eV, and 1859.0 eV. In the XAFS spectrum of the present invention, no absorption is observed from 1850.0 eV to 1860.0 eV, thus confirming that the silicon oxide film is amorphous.

The adjustment of the intensity ratio P2 in the barrier film can be performed in the same manner as the adjustment of the intensity ratio P1.

[Covering Layer]

The covering layer 130 (not shown) formed on the deposition film 120 as necessary is a covering layer which protects the deposition film mechanically and chemically and improves the barrier performance.

The covering layer is formed by applying a barrier coating agent onto the deposition film and then solidifying it. The barrier coating agent can be formed using a water-based emulsion or a solvent-based emulsion, or a solution.

Specific examples of the water-based emulsion include a polyamide-based emulsion, a polyethylene-based emulsion, a polyurethane-based emulsion, a water-soluble polymer and the like, and specific examples of the solvent-based emulsion include a polyester-based emulsion and the like.

As the polyurethane-based emulsion, for example, a mixture solution of a polyurethane-based emulsion and an emulsion of an oxazoline group-containing polymer is preferably used. Furthermore, the polyurethane-based emulsion may contain a silane coupling agent.

As the water-soluble polymer, a polyvinyl alcohol-based resin or an ethylene-vinyl alcohol copolymer can be used alone. Alternatively, a polyvinyl alcohol-based resin and an ethylene-vinyl alcohol copolymer can be used in combination.

As the polyvinyl alcohol-based resin, generally, those obtained by saponification of polyvinyl acetate can be used. The polyvinyl alcohol-based resin may be a partially saponified polyvinyl alcohol resin with several tens of percent of acetate groups remaining, a completely saponified polyvinyl alcohol with no acetate groups remaining, or a modified polyvinyl alcohol-based resin with modified OH-groups. The polyvinyl alcohol-based resin is required to have a saponification degree of at least allowing crystallization that improves the hardness of the gas barrier coating film, and the saponification degree is preferably 70% or more. The polyvinyl alcohol resin with the polymerization degree within a range of about 100 to 5,000 can be used. Examples of such a polyvinyl alcohol-based resin include an RS resin "RS-110 (saponification degree: 99%, polymerization degree: 1,000)" manufactured by Kuraray Co., Ltd., "Gohsenol NM-14 (saponification degree: 99%, polymerization degree: 1,400)" manufactured by The Nippon Synthetic Chemical Industry Co., Ltd., and the like.

As the ethylene-vinyl alcohol copolymer, a saponification product of a copolymer of ethylene and vinyl acetate, that is, a product obtained by saponifying an ethylene-vinyl acetate random copolymer can be used. For example, the saponification products include from a partially saponified product with several tens of mol percent of acetate groups remaining to a completely saponified product with several mol percent of acetate groups or no acetate groups remaining, and are not particularly limited. However, from the viewpoint of the barrier properties, the lower limit of the saponification degree is preferably 80% or more, more preferably 90% or more, and further preferably 95% or more. The upper limit is 100% or less.

(Method for Producing Barrier Film)

The barrier film 100A shown in FIG. 1 is formed by forming a deposition film 120 on the surface of a polypropylene base material (base material 100) including the above base layer 115, preferably by a PVD method. The transport speed of the base material 100 in the vapor deposition process is preferably 180 m/min or more, and more preferably 300 m/min or more and 1,000 m/min or less.

(Plasma Pretreatment Process)

Inert gas alone, oxygen alone, or a gas mixture of an oxygen gas and an inert gas as the plasma source gas which is a plasma raw material gas to be supplied in the plasma pretreatment process before film-forming is supplied from a gas storing section through a flow rate controller while measuring the gas flow rate. Examples of the inert gas include one or a mixture of two or more selected from the group consisting of argon, helium, and nitrogen.

For the plasma treatment, it is preferred to use an inert gas alone. As the other gas, a gas mixture of oxygen gas and inert gas may be used. The mixture ratio of oxygen gas/inert gas is preferably 6/1 to 1/1, and more preferably 5/2 to 3/2.5.

(Film-Forming Process)

SiO and/or $SiO_2$ is/are preferably used as the vapor deposition material in the film-forming process.

In the film-forming process, the vapor deposition material is preferably heated by an EB (electron beam) heating system or an induction heating system, and an EB heating system is more preferred. Furthermore, when the vapor deposition material is heated by the induction heating system, a method of supplying plasma between the surface of the base material 100 and the evaporation mechanism by a plasma supply mechanism, that is, plasma assistance during vapor deposition, may be used as necessary.

The wound body of the barrier film after the film-forming process may be subjected to an aging treatment (heat treatment) for a predetermined period of time. Specifically, the conditions are a temperature of 80°C for 168 hours, for example. This provides the effect of improving transmittance, which is effective when transparency is required for the packaging container.

(Covering Layer-Forming Process)

A covering layer 130 may be formed on the deposition film 120 as necessary. After forming the covering layer 130, an aging treatment may be further performed.

(Laminate)

FIG. 2 is a cross-sectional view illustrating an example of the laminate including the barrier film of the present embodiment. This laminate 200 is a laminate using the barrier film 100A of FIG. 1. That is, the polypropylene layer 110, the base layer 115, and the deposition film 120 constitute the barrier film 100A. One surface of the first polypropylene base material 110 side of the barrier film is laminated to the sealant layer 150 through a first adhesive layer 161, and the other surface of the deposition film 120 side of the barrier film is laminated to the second polypropylene base material 140 through an adhesive layer 162. That is, it has a three-layer film structure of second polypropylene base material 140/second adhesive layer 162/barrier film/first adhesive layer 161/sealant layer 150, with the barrier film as the intermediate layer. The structure other than the barrier film 100A will be described below.

[Adhesive Layer]

The surface of the polypropylene layer 110 side of the barrier film is laminated to the sealant layer 150 through a first adhesive layer 161, and the surface of the covering layer 130 side of the barrier film is laminated to the second polypropylene base material 140 through an adhesive layer 162. This can improve the adhesion between the barrier film and the sealant layer, and the adhesion between the first polypropylene base material and the second base material, and suppress deterioration of barrier properties during heat sterilization treatments such as retorting and boiling.

The first adhesive layer 161 and the second adhesive layer 162 may be any of a 1-part curing adhesive, a 2-part curing adhesive, and a non-curing adhesive. The adhesive may be a solvent-free adhesive or a solvent-based adhesive suitable for dry lamination.

Examples of the solvent-free adhesives, i.e., non-solvent laminating adhesive, include a polyether-based adhesive, a polyester-based adhesive, a silicone-based adhesive, an epoxy-based adhesive, and a urethane-based adhesive. Among them, the urethane-based adhesive is preferred, and the 2-part curing urethane-based adhesive is more preferred.

Examples of the solvent-based adhesive include a rubber-based adhesive, a vinyl-based adhesive, an olefin-based adhesive, a silicone-based adhesive, an epoxy-based adhesive, a phenol-based adhesive, and a urethane-based adhesive. Among them, the urethane-based adhesive is preferred, and the 2-part curing urethane adhesive is more preferred.

The thickness of the adhesive layer is preferably 0.1 μm or more and 10 μm or less, more preferably 1 μm or more and 7 μm or less, and still more preferably 3 μm or more and 5 μm or less. The lower limit of the thickness of the adhesive layer is, for example, preferably 0.1 μm or more, more preferably 1 μm or more, and still more preferably 3 μm or more. The upper limit of the thickness of the adhesive layer is preferably 10 μm or less, more preferably 7 μm or less, and still more preferably 5 μm or less.

[Second Polypropylene Base Material]

The second polypropylene base material 140 is laminated to the surface of the covering layer 30 side of the barrier film through a second adhesive layer 162. Here, it is possible to use, as the second polypropylene base material, a conventionally known biaxially oriented polypropylene film (OPP film).

In the case of a three-layer structure as shown in FIG. 2, a printing layer (not shown) may be formed on the surface of the outermost layer of the second polypropylene base material 140, or may be formed on the surface of the second adhesive layer 162 side of the second polypropylene base material 140.

[Sealant Layer]

The sealant layer 150 contains a resin material which can be fused to each other by heat. Examples of the resin material which can be fused to each other by heat include polyolefins, and specific examples thereof include polyethylenes such as low-density polyethylene, linear low-density polyethylene, and medium-density polyethylene, polypropylenes, polybutenes, methylpentene polymers, and cyclic olefin copolymers.

The sealant layer is preferably made of polypropylene. As a result, the three-layer film is made entirely of the polypropylene, thus making it possible to achieve the packaging material that is a mono-material. After collecting used packaging material, there is no need to separate the base material and the sealant layer, which can improve the recyclability of the packaging material. When the sealant layer is made of polypropylene, the oil resistance can also be improved, resulting in a sealant layer which can withstand a heat sterilization treatment.

The content of the polypropylene in the sealant layer is preferably 70% by mass or more, more preferably 80% by mass or more, still more preferably 90% by mass or more, and yet more preferably 95% by mass or more. This can, for example, improve the recyclability of the packaging material.

When the sealant layer is made of polypropylene, the content of the polypropylene relative to the total amount of the resin material included in the laminate is preferably 80% by mass or more, more preferably 85% by mass or more, still more preferably 88% by mass or more, and particularly preferably 90% by mass or more. This enables, for example, the production of a packaging material that is a mono-material using the laminate, thereby improving the recyclability of the packaging material.

Examples of the polypropylene include propylene homopolymers, propylene random copolymers such as a propylene-$\alpha$-olefin random copolymer, and propylene block copolymers such as a propylene-$\alpha$-olefin block copolymer. The details of the $\alpha$-olefin are as mentioned above. From the viewpoint of the heat-sealing properties, the density of the polypropylene is, for example, 0.88 g/cm$^3$ or more and 0.92 g/cm$^3$ or less. The density is measured in accordance with JIS K7112, particularly Method D (density-gradient tube method, 23°C). From the viewpoint of reduction in environmental impact, biomass-derived polypropylene and/or recycled polypropylene may be used.

The sealant layer may contain additives. Examples of additives include a crosslinking agent, an antioxidant, an antiblocking agent, a slip agent, an ultraviolet absorber, a light stabilizer, a filler, a reinforcing agent, a lubricant, an antistatic agent, a pigment, and a modifying resin. For example, the sealant layer may contain the antistatic agent. This makes it possible to suppress the generation of static electricity on the surface of the laminate, and for example, to suppress the adhesion between laminates.

The sealant layer may have a single-layer structure or a multi-layer structure. The thickness of the sealant layer is preferably 10 $\mu$m or more and 200 $\mu$m or less, and more preferably 20 $\mu$m or more and 150 $\mu$m or less. The lower limit of the thickness of the sealant layer is preferably 10 $\mu$m or more, and more preferably 20 $\mu$m or more. The upper limit of the thickness of the sealant layer is preferably 200 $\mu$m or less, and more preferably 150 $\mu$m or less. When the thickness is the lower limit or more, for example, the lamination strength of the packaging material including the laminate can be further improved. When the thickness is the upper limit or less, for example, the processability of the laminate can be further improved. When a pouch (particularly a retort pouch) is produced from the laminate, the thickness of the sealant layer is more preferably 30 $\mu$m or more and 100 $\mu$m or less. When a pouch (particularly a retort pouch) is produced from the laminate, the lower limit of the thickness of the sealant layer is more preferably 30 $\mu$m or more. When a pouch (particularly a retort pouch) is produced from the laminate, the upper limit of the thickness of the sealant layer is more preferably 100 $\mu$m or less.

From the viewpoint of heat-sealing properties, the sealant layer is preferably an unoriented resin film, and more preferably an unoriented polyolefin film, for example, a non-oriented polypropylene film. The resin film can be produced by, for example, a casting method, a T-die method, or an inflation method. The sealant layer may be laminated through an adhesive layer as in the present embodiment, or may be formed by melt-extruding a resin material which can be fused to each other by heat onto the barrier film.

[Other Lamination Examples]

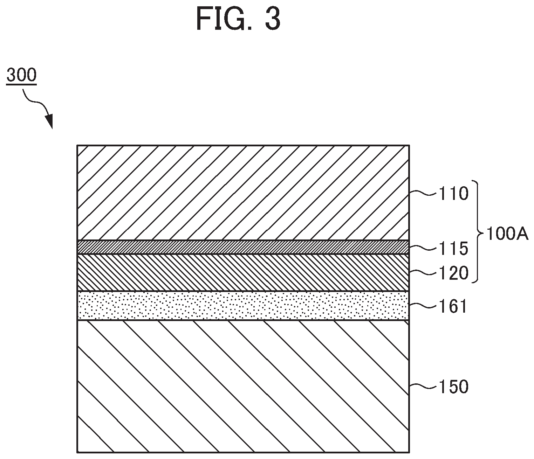

The laminate 300 in FIG. 3 is an example in which the deposition film 120 of the barrier film A is laminated to the sealant layer 150 through the first adhesive layer 161. Thus, in the present invention, the laminate is not limited to a three-layer film structure, but may also have a two-layer structure.

[Packaging Products]

The above laminate can be used as a packaging product such as a packaging bag for containing contents such as foods by forming it into a bag shape with the sealant layer on the inside. The laminate of the present invention is a heat-sterilized laminate which can be used for the packaging bag containing retort foods or boiled foods.

The heat sterilization treatment means not only a retort treatment but also a boiling treatment. The boiling treatment means, for example, heat sterilization at 60 to 100°C for 10 to 60 minutes.

The retort treatment means a pressure heat sterilization treatment at 100 to 140°C. The pressure heat sterilization is preferably a pressure heat sterilization in which the F value, which is a concept that represents the integral value of the heat load, is 4 or more, and more specifically a pressure heat sterilization at 121°C for 3 minutes or more, or at 120°C for 4 minutes or more as stipulated by the Food Sanitation Act. More specifically, the treatment is generally performed at 120 to 130°C for 15 to 60 minutes, but may also be performed under treatment conditions of 105 to 120°C for 15 to 60 minutes, or 130 to 140°C for 15 to 60 minutes. In the present application, the treatment conditions of 130 to 140°C for 15 to 60 minutes is referred to as a high retort treatment.

(Wetted Peel Strength)

In the laminate of the present disclosure, after a retort treatment at 128°C for 16 minutes, the wetted peel strength when the film including the polypropylene base film is peeled off from the film including the barrier film and the heat sealant film in accordance with JIS K 6854-2:1999 is preferably 0.3 N/15 mm or more, more preferably 0.5 N/15 mm or more, still more preferably 1.0 N/15 mm or more, yet more preferably 2.0 N/15 mm or more, particularly preferably 2.1 N/15 mm or more, and most preferably 3.0 N/15 mm or more. When the wetted peel strength is the lower limit or more, peeling between layers or cohesive peeling within layers can be suppressed if the laminate of the present disclosure is used for heat sterilization. A specific method for measuring the wetted peel strength will be described below.

Examples of the film including a polypropylene base film include a film composed of only a polypropylene base film, a printing film having a printing layer formed on one surface of a polypropylene base film, and the like. Examples of the film including a barrier film and a heat sealant film include a film having a barrier film and a heat sealant film laminated through an adhesive layer.

As the tensile tester, a TENSILON universal testing machine manufactured by Orientec Co., Ltd. is used. First, the laminate of the present disclosure is cut into an A4 size, folded in half at the long side, with the heat sealant film facing itself, and three sides including the fold are heat sealed to a width of 7 mm to produce a three-sides sealed packaging bag. This packaging bag is filled with 200 mL of tap water, and the remaining side is heat-sealed to seal the bag, thereby completing a retort packaging bag filled with the contents. The retort packaging bag is subjected to a retort treatment using steam at 128°C for 16 minutes. Next, the laminate is cut from the packaging bag after the retort treatment to produce rectangular test pieces with a short side of 15 mm so that the long side direction of the test piece coincides with the longitudinal direction (MD direction) of the polymer film 10, and then the film including the polypropylene base film of the laminate and the film including the barrier film and heat sealant film are peeled off 15 mm in the long side direction of the test pieces. Thereafter, each part where the film including the polypropylene base film and the film including the barrier film and heat sealant film have been peeled off is held by a pair of gripping tools of the measuring device. When viewed along the longitudinal direction of the test piece, water is dropped using a dropper onto the boundary between the part where the film including the polypropylene base film and the film including the barrier film and heat sealant film remain bonded, and the part where the film including the polypropylene base film and the film including the barrier film and heat sealant film have been peeled off. The pair of gripping tools is pulled in opposite directions (180° peel) perpendicular to the plane direction of the portion where the film including the polypropylene base film and the film including the barrier film and heat sealant film are still laminated, at a speed of 50 mm/min, and the average value of the tensile stress in the stable region is measured. When the pulling starts, the distance S between the gripping tools is set at 30 mm, and when the pulling ends, the distance S between the gripping tools is set at 60 mm. The change in tensile stress relative to the distance S passes through a first region and then enters a second region (stable region) where the rate of change is smaller than that of the first region. The average value of the tensile stress in the stable region is measured. The laminate is cut from the packaging bag after the retort treatment to produce rectangular test pieces with short sides of 15 mm so that the long side direction of the test pieces coincides with the horizontal direction (TD direction) of the polymer film 10, and the film including the polypropylene base film of the laminate and the film including the barrier film and heat sealant film are peeled off from the test pieces by 15 mm in the long side direction. Thereafter, the average value of the tensile stress in the stable region is measured in the same manner as above. Of the smaller and larger measured values obtained above, the smaller measured value is taken as the wetted peel strength when the film including the polypropylene base film in the laminate is peeled from the film including the barrier film and the heat sealant film.

In the laminate of the present disclosure, the wetted peel strength basically corresponds to the adhesive strength between the base layer and the deposition film. However, if the adhesion strength between the base layer and the deposition film becomes too strong, cohesive failure of the adhesive layer between the polypropylene base film and the barrier film, or peeling between the polypropylene base film and the printing layer may occur. In such cases, the cohesive failure strength or the peel strength between the polypropylene base film and the printing layer corresponds to the wetted peel strength. The peeled interface can be confirmed by measuring the wetted peel strength and then evaluating the peeled portion of the test piece by FT-IR (ATR method) and XPS.

When measuring the wetted peel strength of a commercially available heat-sterilized food pouch, the laminate constituting the packaging bag can be cut to produce test pieces so that the long side direction of the test piece coincides with the width direction of the packaging bag, and the laminate constituting the packaging bag can also be cut to produce test pieces so that the long side direction of the test piece coincides with the direction perpendicular to the width direction of the packaging bag. Thereafter, the wetted peel strength of the two test pieces is measured using a tensile tester, and the smaller measured value is taken as the wetted peel strength. The specific method for measuring the wetted peel strength of the test piece is the same as above.

EXAMPLES

The present invention will be described in further detail below by Examples, but the present invention is not limited to these descriptions in any way. First, except for Comparative Example 1, barrier films according to Examples 1 to 18 and Comparative Examples 1 to 5 were produced using a conventionally known vacuum deposition apparatus based on the PVD method (a CVD apparatus in Comparative Example 1). Table 1 collectively shows the pretreatment conditions, vapor deposition conditions and the like.

(Example 1)

A base layer made of 100% by mass of a copolymer of dicarboxylic acid and hexamethylenediamine, consisting of isophthalic acid / terephthalic acid in a molar ratio of 7/3, which is an amorphous aromatic polyamide (referred to as PA1 in Table 1), a polypropylene base material layer made of an acid-modified polypropylene random copolymer as a first layer, homopolypropylene as a second layer, and a layer consisting of a copolymer of propylene, ethylene, and 1-butene as a third layer, were co-extruded in the order of base layer / first layer / second layer / third layer, and then oriented 5 times in the machine direction (MD direction) and 10 times in the transverse direction (TD direction) using a sequential biaxial orientation machine to produce a 20 μm thick base film (base material 100) (referred to as OPP in Table 1) including the base layer (0.7 μm), the first layer (1.5 μm), the second layer (17.1 μm), and the third layer (0.7 μm).

Before the film-forming process, the following in-line pretreatment process was performed.

<Pretreatment Process>

Using a plasma pretreatment mechanism, the surface of the base material 100 (surface of the base layer 115) was subjected to a plasma pretreatment under the following conditions.

<Pretreatment Conditions>

    Transport speed of base material: 360 m/min
    Electrode: Ti target
    Power source: DC power source
    Power output: 10 kW
    Introduced gas type: Ar
    Introduced gas amount: 2,000 sccm
    Pretreatment compartment pressure: $2.0 \times 10^{-1}$ Pa

Next, in the film-forming process, a deposition film containing silicon oxide was formed by a vacuum vapor deposition method using an evaporation mechanism of an EB (electron beam) heating system. Silicon oxide (SiO) (referred to as Si1 in Table 1) was used as the vapor deposition material, and the film was formed at a transport speed of 360 m/min so as to have a transmittance of 70%. The transmittance was measured at a wavelength of 365 nm, and the transmittance when light was transmitted through only the base material was set at 100%. By setting the transport speed and transmittance, the output of EB is changed accordingly. For example, the faster the transport speed, the higher the EB output, and the lower the transmittance, the higher the EB output. The thickness of the deposition film was 34 nm. The pressure during vapor deposition was 0.2 Pa.

(Example 2)

The barrier film of Example 2 was produced in the same manner as Example 1, except that the transport speed in the pretreatment process and the film-forming process was 300 m/min, the film was formed to have a transmittance of 66%, and the thickness of the deposition film was 43 nm.

(Example 3)

The barrier film of Example 3 was produced in the same manner as Example 1, except that the transport speed in the pretreatment process and the film-forming process was 360 m/min, the film was formed to have a transmittance of 86%, and the thickness of the deposition film was 17 nm.

(Example 4)

The barrier film of Example 4 was produced in the same manner as Example 1, except that the transport speed in the pretreatment process and the film-forming process was 360 m/min, the film was formed to have a transmittance of 73%, and the thickness of the deposition film was 30 nm.

(Example 5)

The barrier film of Example 5 was produced in the same manner as Example 1, except that the transport speed in the pretreatment process and the film-forming process was 200 m/min, the film was formed to have a transmittance of 62%, and the thickness of the deposition film was 61 nm.

(Example 6)

The barrier film of Example 6 was produced in the same manner as Example 1, except that the pretreatment process was not performed.

(Example 7)

The barrier film of Example 7 was produced in the same manner as Example 1, except that a mixture of 80% by mass of silicon oxide (SiO) and 20% by mass of silicon dioxide ($SiO_2$) (referred to as Si2 in Table 1) was used as the deposition material, the transport speed was 240 m/min, the film was formed to have a transmittance of 71%, and the thickness of the deposition film was 45 nm and an aging treatment was performed at 80°C for 168 hours after vapor deposition.

(Example 8)

The barrier film of Example 8 was produced in the same manner as in Example 7, except that a mixture of 60% by mass of silicon oxide (SiO) and 40% by mass of silicon dioxide ($SiO_2$) (represented as Si3 in Table 1) was used as the deposition material, the transport speed was 240 m/min, the film was formed to have a transmittance of 80%, and the thickness of the deposition film was 60 nm.

(Example 9)

The barrier film of Example 9 was produced in the same manner as Example 1, except that a mixture solution of acrylic polyol and tolylene diisocyanate was coated onto the deposition film and dried at 100°C for 10 seconds to form a urethane-based covering layer with a thickness of 0.6 $\mu$m.

(Example 10)

The barrier film of Example 10 was produced in the same manner as in Example 1, except that an aging treatment was performed at 55°C for 168 hours after vapor deposition.

(Example 11)

The barrier film of Example 11 was produced in the same manner as in Example 1, except that an aging treatment was performed at 80°C for 168 hours after vapor deposition.

(Example 12)

The barrier film of Example 12 was produced in the same manner as in Example 4, except that a mixture of 50% by mass of a copolymer of dicarboxylic acid and hexamethylenediamine, which is an amorphous aromatic polyamide, in a molar ratio of isophthalic acid / terephthalic acid of 7/3, and 50% by mass of a copolymer of metaxylenediamine and adipic acid, which is a crystalline aromatic polyamide, (referred to as PA2 in Table 1) was used as the base layer.

(Example 13)

The barrier film of Example 13 was produced in the same manner as in Example 4, except that a mixture of 80% by mass of a copolymer of dicarboxylic acid and hexamethylenediamine, which is an amorphous aromatic polyamide, in a molar ratio of isophthalic acid / terephthalic acid of 7/3, and 20% by mass of a copolymer of metaxylenediamine and adipic acid, which is a crystalline aromatic polyamide, (referred to as PA3 in Table 1) was used as the base layer.

(Example 14)

The barrier film of Example 14 was produced in the same manner as in Example 4, except that a mixture of 86% by mass of a copolymer of dicarboxylic acid and hexamethylenediamine, which is an amorphous aromatic polyamide, in a molar ratio of isophthalic acid / terephthalic acid of 7/3, and 14% by mass of a homopolymer of 6-aminohexanoic acid units synthesized by ring-opening polymerization of ε-caprolactam, which is a crystalline aliphatic polyamide, (referred to as PA4 in Table 1) was used as the base layer.

(Example 15)

The barrier film of Example 15 was produced in the same manner as in Example 4, except that a mixture of 90% by mass of a copolymer of dicarboxylic acid and hexamethylenediamine, which is an amorphous aromatic polyamide in a molar ratio of isophthalic acid / terephthalic acid of 7/3, and 10% by mass of a homopolymer of 6-aminohexanoic acid units synthesized by ring-opening polymerization of ε-caprolactam, which is a crystalline aliphatic polyamide, (referred to as PA5 in Table 1) was used as the base layer.

(Example 16)

The barrier film of Example 16 was produced in the same manner as in Example 1, except that the thickness of the base layer was set at 0.4 μm. The thickness of the base material film of Example 16 was 19.7 μm.

(Example 17)

The barrier film of Example 17 was produced in the same manner as Example 1, except that the thickness of the base layer was set at 1.5 μm. The thickness of the base material film of Example 17 was 20.8 μm.

(Example 18)

A barrier coating agent was prepared on the surface of the deposition film of Example 1 by the following procedure to form a barrier coat layer.

385 g of water, 67 g of isopropyl alcohol, and 9.1 g of 0.5 N hydrochloric acid were mixed to prepare a solution with a pH of 2.2. To this solution, 175 g of tetraethoxysilane as a metal alkoxide was added while cooling to 10°C, thus obtaining a solution A.

14.7 g of polyvinyl alcohol as a water-soluble polymer having a saponification degree of 99% or more and a polymerization degree of 2400, 324 g of water, and 17 g of isopropyl alcohol were mixed to obtain a solution B. The solution A and the solution B were mixed in a mass ratio of 5.5:4.5 to obtain a barrier coating agent. The barrier coating agent was coated onto the surface of the deposition film and then dried at 100°C for 10 seconds. The thickness of the barrier coat layer formed by drying the barrier coating agent was 300 nm. In this manner, the barrier film of Example 18 was produced.

(Comparative Example 1)

The barrier film of Comparative Example 1 was produced in the same manner as in Example 1, except that in the film-forming process, no pretreatment step was performed and a 35 nm thick carbon-containing silicon oxide deposition film (referred to as Si4 in Table 1) was formed using a plasma chemical vapor deposition apparatus (plasma CVD apparatus) under the following conditions.

(Formation Conditions)

- Hexamethyldisiloxane:oxygen gas:helium = 1:10:10 (unit: slm)
- Electrode drum supply power: 22 kW
- Line speed: 40 m/min vapor deposition

(Comparative Example 2)

The barrier film of Comparative Example 2 was produced in the same manner as in Example 7, except that using a mixture of 40% by mass of silicon oxide (SiO) and 60% by mass of silicon dioxide ($SiO_2$) (referred to as Si5 in Table 1) as the vapor deposition material, a film was formed to have a transmittance of 82%, and the thickness of the deposition film was 60 nm.

(Comparative Example 3)

The barrier film of Comparative Example 3 was produced in the same manner as in Example 4, except that the conditions in the film-forming process were changed to a transport speed of 120 m/min and a pressure of 0.8 Pa during vapor deposition.

(Comparative Example 4)

The barrier film of Comparative Example 4 was produced in the same manner as in Example 1, except that in the film-forming process, a plasma pretreatment was performed using a gas mixture of argon and oxygen in a volume ratio of 1:1, and in the continuously transported film-forming section, a resistance heating system was used as a means for heating aluminum on the plasma-treated surface, and aluminum was deposited while introducing oxygen, thus forming an 8 nm thick aluminum oxide (alumina) deposition film by the PVD method (referred to as alumina in Table 1).

(Comparative Example 5)

The barrier film of Comparative Example 5 was produced in the same manner as in Example 1, except that a mixture solution of acrylic polyol and tolylene diisocyanate was coated as the base layer and then dried at 100°C for 10 seconds to form a 0.2 $\mu$m thick urethane-based covering layer (referred to as AC in Table 1).

(Comparative Example 6)

The base film of Comparative Example 6 was produced in the same manner as in Example 1, except that the thickness of the base layer was set at 0.1 $\mu$m, however, since resin starving occurred in the base layer due to orientation, leading to poor film-forming properties, no further evaluation was performed.

(Comparative Example 7)

The base film of Comparative Example 7 was produced in the same manner as in Example 1, except that the thickness of the base layer was set at 5 $\mu$m, however, since the base film exhibited severe curling, no further evaluation was performed.

[Table 1]

| | Polypropylene layer | Base layer (thickness) | Deposition film | Deposition system | Film thickness (nm) | Pretreatment | Aging after vapor deposition | Covering layer |
|---|---|---|---|---|---|---|---|---|
| Example 1 | OPP | PA1(0.7μm) | Si1 | EB | 34 | Presence | Absence | Absence |
| Example 2 | OPP | PA1(0.7μm) | Si1 | EB | 43 | Presence | Absence | Absence |
| Example 3 | OPP | PA1(0.7μm) | Si1 | EB | 17 | Presence | Absence | Absence |
| Example 4 | OPP | PA1(0.7μm) | Si1 | EB | 30 | Presence | Absence | Absence |
| Example 5 | OPP | PA1(0.7μm) | Si1 | EB | 61 | Presence | Absence | Absence |
| Example 6 | OPP | PA1(0.7μm) | Si1 | EB | 34 | Absence | Absence | Absence |
| Example 7 | OPP | PA1(0.7μm) | Si2 | EB | 45 | Presence | 80°C, 168 hours | Absence |
| Example 8 | OPP | PA1(0.7μm) | Si3 | EB | 60 | Presence | 80°C, 168 hours | Absence |
| Example 9 | OPP | PA1(0.7μm) | Si1 | EB | 34 | Presence | Absence | Presence |
| Example 10 | OPP | PA1(0.7μm) | Si1 | EB | 34 | Presence | 55°C, 168 hours | Absence |
| Example 11 | OPP | PA1(0.7μm) | Si1 | EB | 34 | Presence | 80°C, 168 hours | Absence |
| Example 12 | OPP | PA2(0.7μm) | Si1 | EB | 30 | Presence | Absence | Absence |
| Example 13 | OPP | PA3(0.7μm) | Si1 | EB | 30 | Presence | Absence | Absence |
| Example 14 | OPP | PA4(0.7μm) | Si1 | EB | 30 | Presence | Absence | Absence |
| Example 15 | OPP | PA5(0.7μm) | Si1 | EB | 30 | Presence | Absence | Absence |
| Example 16 | OPP | PA1(0.4μm) | Si1 | EB | 34 | Presence | Absence | Absence |
| Example 17 | OPP | PA1(1.5μm) | Si1 | EB | 34 | Presence | Absence | Absence |
| Example 18 | OPP | PA1(0.7μm) | Si1 | EB | 34 | Presence | Absence | Presence |
| Comparative Example 1 | OPP | PA1(0.7μm) | Si4 | CVD | 35 | Absence | Absence | Absence |
| Comparative Example 2 | OPP | PA1(0.7μm) | Si5 | EB | 60 | Presence | 80°C, 168 hours | Absence |
| Comparative Example 3 | OPP | PA1(0.7μm) | Si1 | EB | 30 | Presence | Absence | Absence |
| Comparative Example 4 | OPP | PA1(0.7μm) | Alumina | Resistance heating | 8 | Presence | Absence | Absence |
| Comparative Example 5 | OPP | AC(0.2μm) | Si1 | EB | 34 | Presence | Absence | Absence |

[Acquisition and Analysis of XAFS Spectrum]

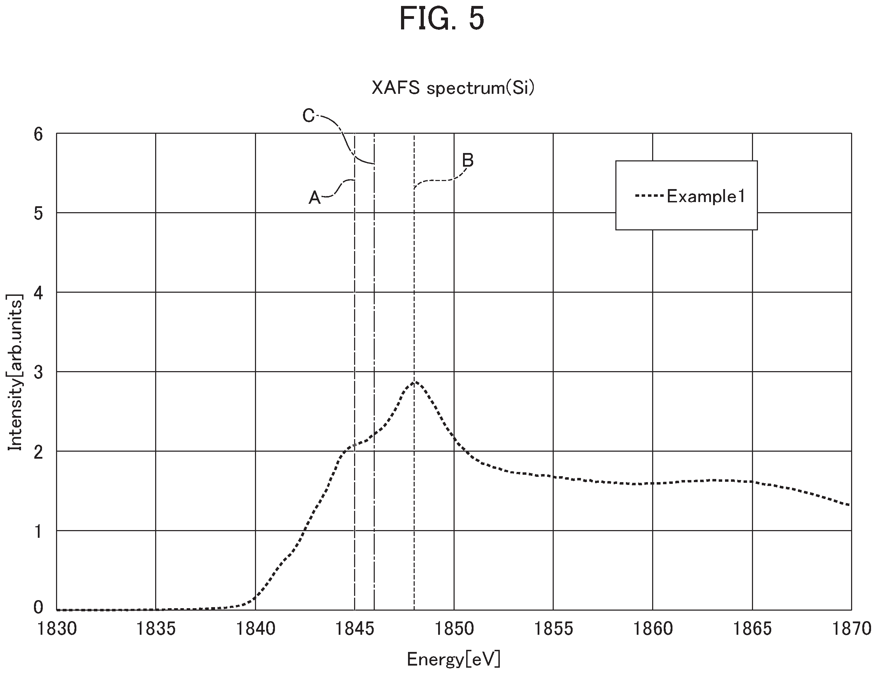

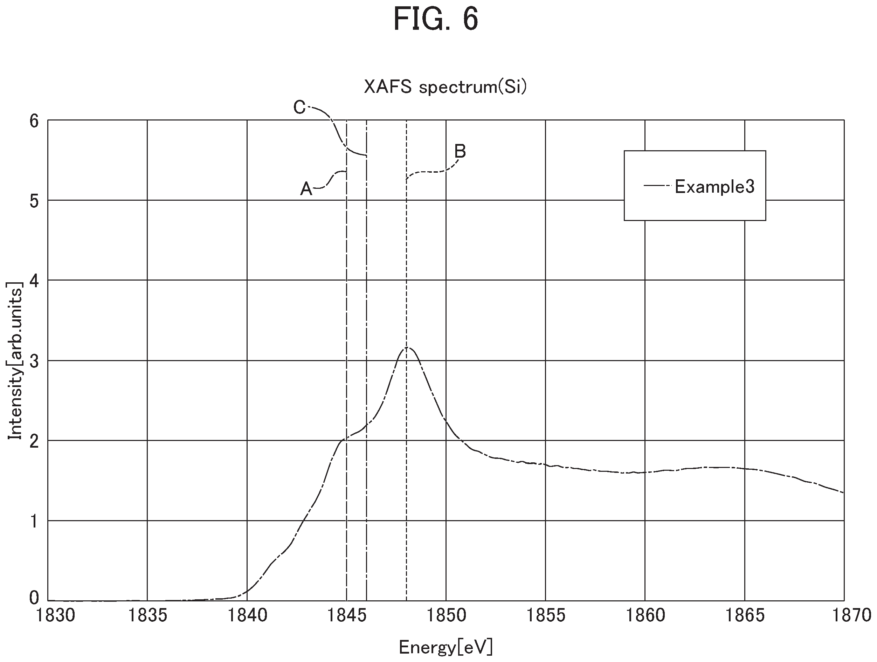

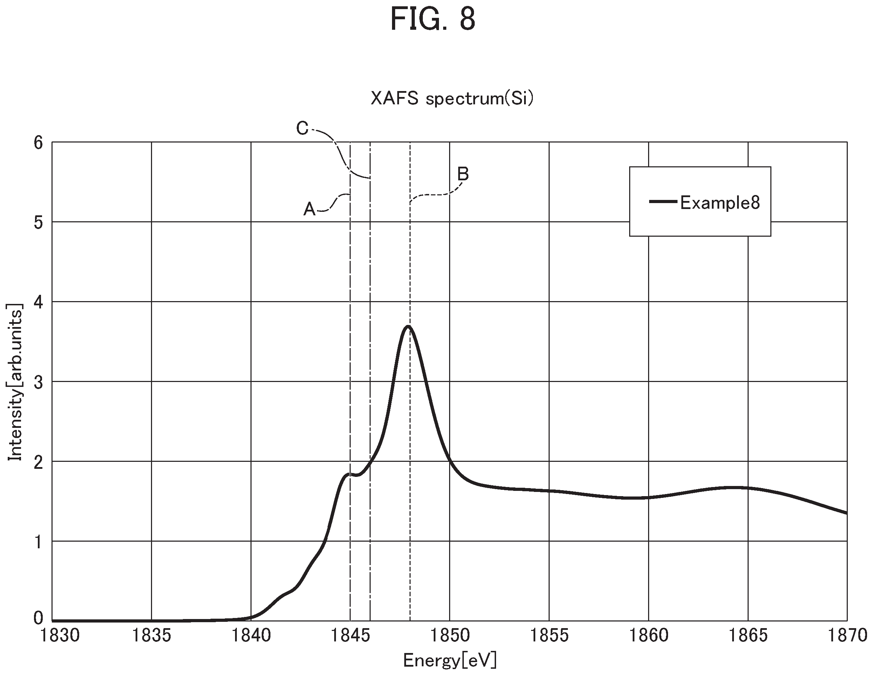

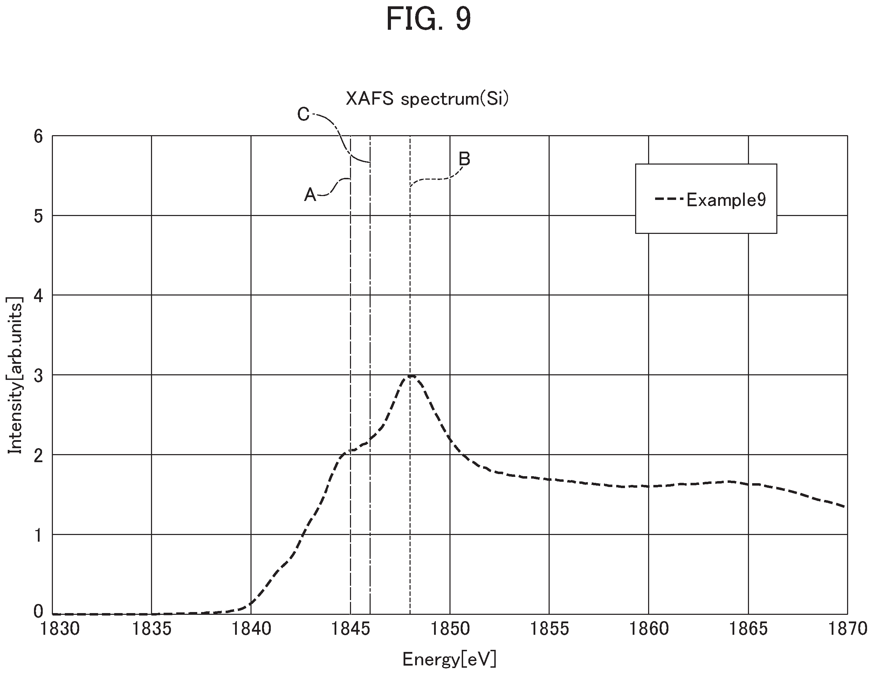

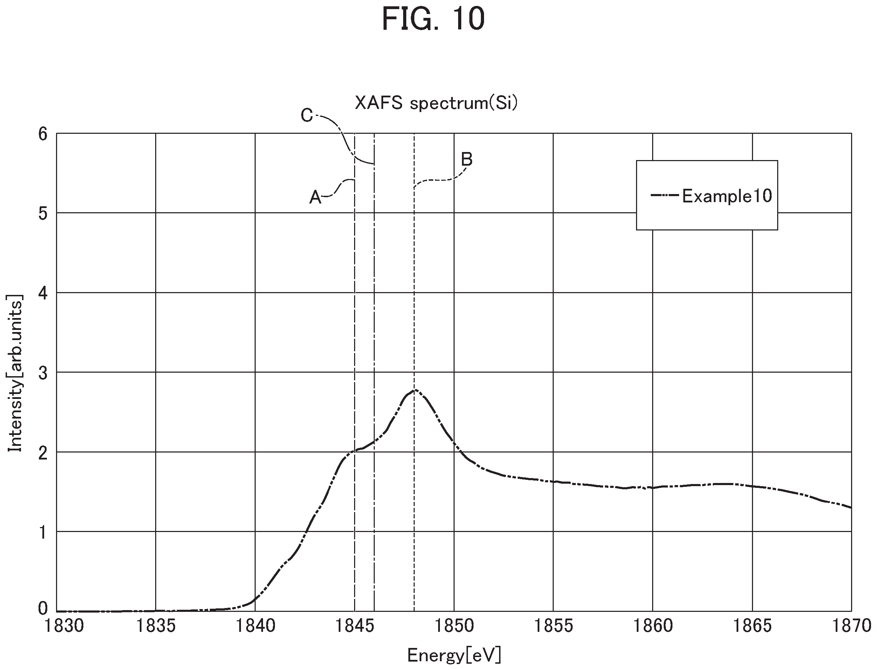

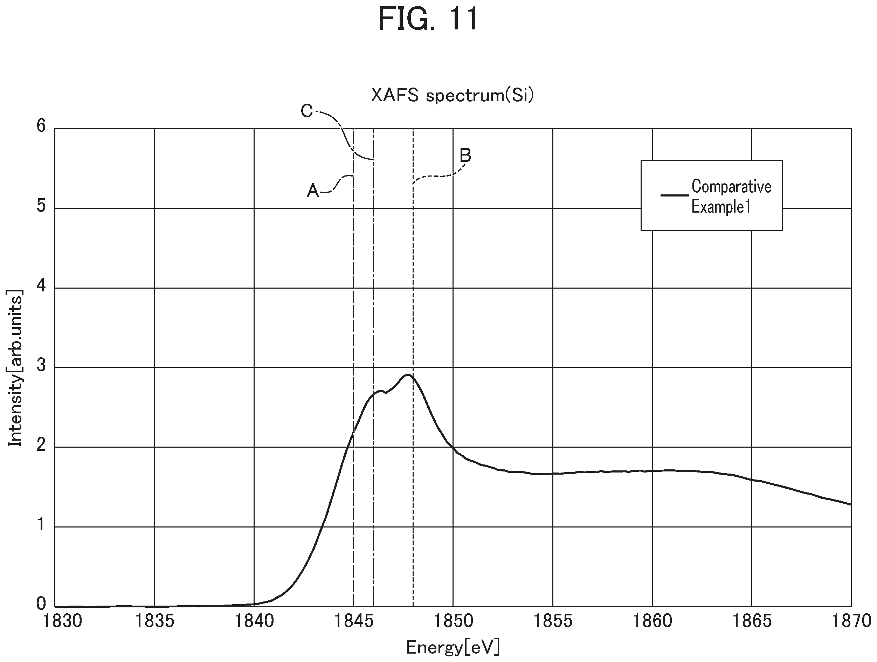

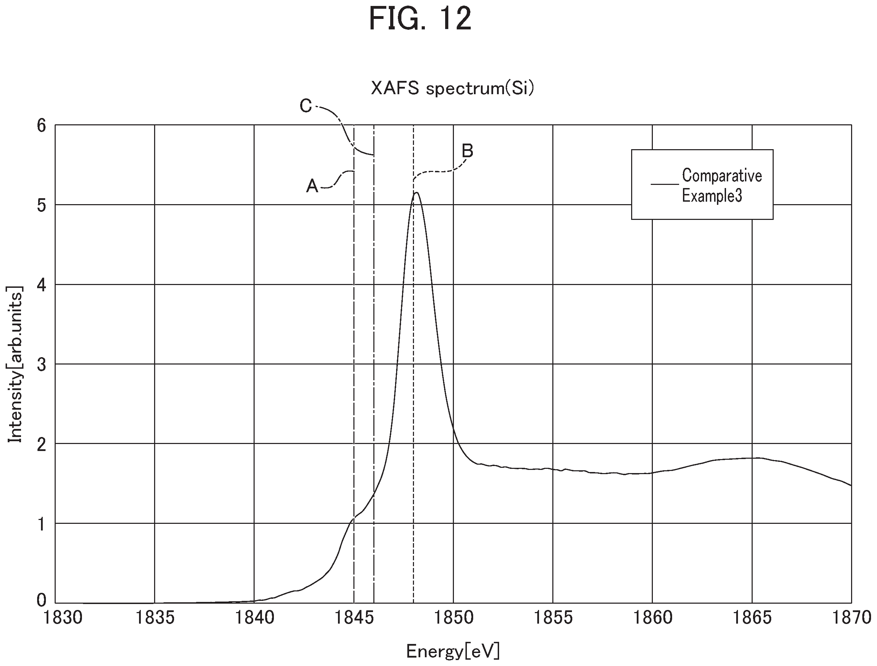

XAFS spectra of the barrier films of Example 1 to 18 and Comparative Example 1 to 3 were measured from the surface side of the barrier film (from the surface side of the deposition film or the surface side of the covering layer, and the XAFS spectrum of Example 18 was measured from the surface side of the deposition film before the covering layer was formed) under the following measurement conditions. Among them, the results of Examples 1, 3, and 7 to 10 are shown in FIG. 5 to FIG. 10, and the results of Comparative Examples 1 and 3 are shown in FIG. 11 and FIG. 12. The vertical axis of the figure is the intensity of generated fluorescent X-rays (in the figure, shown as absorption intensity (a.u.)), and the horizontal axis is the light (or X-ray) energy (eV). In Comparative Example 5, because of high oxygen transmission rate of the barrier film alone, measurement by XAFS was not performed.

<Acquisition of XAFS spectrum>

- Used line: Aichi Synchrotron Radiation Center BL6N1

- Acceleration energy: 1.2 GeV
- Spectrometer type: double crystal monochromator
- Analyzing crystal: InSb(111)
- Beam size: 2.0 mm in the horizontal direction $\times$ 1.0 mm in vertical
- Incident angle on sample: 45°
- Upstream slit size: 10 mm in the horizontal direction $\times$ 3.0 mm in vertical
- Measurement method: partial fluorescence yield
- Light quantity monitor (I0): Au mesh
- Energy range (Si K-edge): 1,820 to 1,890 eV
- Energy step:

     1,820 to 1,837 eV: 1.0 eV/step
     1,837 to 1,860 eV: 0.2 eV/step
     1,860 to 1,890 eV: 0.5 eV/step
     (Dwell time: all 4 s/point)

- Degree of vacuum in measurement chamber (when no sample is placed): $1.0 \times 10^{-6}$ Pa or less
- Energy calibration: peak position at the S-K edge of $K_2SO_4$ is calibrated to 2481.70 eV

<XAFS Spectral Analysis>

The intensity values were normalized such that the absorption spectral intensity value at an absorbed X-ray energy value of 1,828 to 1,833 eV was 0 and the absorption spectral intensity value at an absorbed X-ray energy value of 1883.5 to 1888.5 eV was 1.

<Interpretation of XAFS Spectra>

For silicon oxide, a peak is detected near 1,848 eV in the case of high oxide (SiOx, x=2) and near 1,845 eV for intermediate oxides (SiOx, x<2). Silicon carbide is detected near 1,846 eV. Therefore, each detection intensity was calculated as follows. Detection intensity near 1,848 eV: maximum value of 1847.0 to 1849.4 eV (B in FIG. 4 and subsequent figures)

Detection intensity near 1,845 eV: maximum value of 1843.8 to 1845.2 eV (A in FIG. 4 and subsequent figures)
Detection intensity near 1,846 eV: maximum value of 1845.4 to 1846.4 eV (C in FIG. 4 and subsequent figures)
Subsequently, P1 = (peak intensity near 1,845 eV)/(peak intensity near 1,848 eV) was calculated as an indicator of the oxidation degree of silicon oxide, and P2 = (peak intensity near 1,846 eV)/(peak intensity near 1,848 eV) was calculated as an indicator of the silicon carbide content.

[Table 2]

|  | XAFS Intensity ratio P1 | XAFS Intensity ratio P2 |
|---|---|---|
| Example 1 | 0.73 | 0.80 |
| Example 2 | 0.74 | 0.81 |
| Example 3 | 0.65 | 0.72 |
| Example 4 | 0.70 | 0.78 |
| Example 5 | 0.76 | 0.83 |
| Example 6 | 0.72 | 0.79 |
| Example 7 | 0.55 | 0.64 |
| Example 8 | 0.40 | 0.49 |
| Example 9 | 0.69 | 0.77 |
| Example 10 | 0.73 | 0.80 |
| Example 11 | 0.64 | 0.71 |
| Example 12 | 0.70 | 0.78 |
| Example 13 | 0.70 | 0.78 |
| Example 14 | 0.70 | 0.78 |
| Example 15 | 0.70 | 0.78 |
| Example 16 | 0.73 | 0.80 |
| Example 17 | 0.73 | 0.80 |
| Example 18 | 0.73 | 0.80 |
| Comparative Example 1 | 0.80 | 0.93 |
| Comparative Example 2 | 0.34 | 0.40 |
| Comparative Example 3 | 0.22 | 0.31 |
| Comparative Example 4 | - | - |
| Comparative Example 5 | - | - |

<Production of Laminate>

For the barrier films of Examples and Comparative Examples, the surface on the covering layer 130 side or the surface on the deposition film 120 side, and a second biaxially oriented polypropylene film 140 (thickness of 20 $\mu$m) was adhered via a second adhesive layer 162 by a dry lamination method, using a polyurethane-based 2-part curing solvent-based adhesive. Furthermore, the surface of the barrier film opposite to the deposition film 120 and a sealant layer 150 (60 $\mu$m thick non-oriented polypropylene film) was adhered via a first adhesive layer 161 by a dry lamination method, using a 2-part curing solvent-based adhesive to produce laminates of Examples and Comparative Examples as shown in FIG. 2.

<High Retort Treatment>

The laminates of Examples and Comparative Examples were subjected to a high retort treatment at 130°C for 60 minutes.

<Measurement of Barrier Properties of Barrier Films and Laminates>

The values of the water vapor transmittance and oxygen transmittance of the barrier films of Examples and Comparative Examples and the laminate using the same were measured. The results are shown in Table 4.
The oxygen transmittance (cc/(m$^2$·day·atm), expressed as "OTR" in the table) was measured with an oxygen transmittance measurement apparatus (manufactured by MOCON, Inc., product name: "OX-TRAN 2/20") under measurement conditions of 23°C and 90% RH in accordance with JIS K 7126-2.

The water vapor transmittance (g/(m$^2$·day), expressed as "WVTR" in the table) was measured with a water vapor transmittance measurement apparatus (manufactured by MOCON, Inc., product name: "PERMATRAN-W 3/31") under measurement conditions of 40°C and 100% RH in accordance with JIS K 7129 B method.

<Measurement of Barrier Properties of Barrier Films and Laminates>

The values of the water vapor transmittance and oxygen transmittance of the barrier films of Examples and Comparative Examples and the laminate using the same after the Gelbo Flex test under the following conditions were measured. The results are shown in Table 3.

<Gelbo Flex Test after Retort Treatment>

After the retort treatment at 128°C for 16 minutes, the laminates using the barrier films of Examples and Comparative Examples were subjected to the Gelbo Flex test under the following conditions in accordance with ASTM F392, and the values of the water vapor transmittance and oxygen transmittance after the test were measured. The results are shown in Table 3. Gelbo Flex test conditions

- Testing machine: BE-1005 Gelbo Flex Tester, manufactured by TESTER SANGYO CO., LTD.
- Sample: A laminate of A4 size (210 mm × 297 mm) set in a cylindrical shape on the testing machine.
- Rotation amount: 400° rotation
- Stroke: 80 mm
- Number of times: 10 times

<Adhesion Test>

(Peel Strength)

The peel strength of the above laminates was measured before and after the retort treatment at 128°C for 16 minutes, as normal strength and wetted peel strength, in accordance with JIS K 6854-2:1999, by 180-degree peeling (unit: N/15 mm). The results are shown in Table 4. The measuring instrument used was a TENSILON universal material testing machine, product name: STA-1150, manufactured by Orientec Co., Ltd. The peel strength basically corresponds to the adhesive strength between the base layer and the deposition film.

(Normal Peeling after Retorting)

The laminate was cut into an A4 size, folded in half at the long side, with the heat sealant film facing itself, and three sides including the fold are heat sealed to a width of 7 mm to produce a three-sides sealed packaging bag. This packaging bag was filled with 200 mL of tap water, and the remaining side was heat-sealed to seal the bag, thereby completing a retort packaging bag filled with the contents. The retort packaging bag was subjected to a retort treatment using steam at 128°C for 16 minutes. Next, the laminate was cut from the packaging bag after the retort treatment so that the long side direction of the test piece coincided with the MD direction, to produce a rectangular test piece with a short side of 15 mm. For the test piece, the film including the second biaxially oriented polypropylene film 140 of the laminate (hereinafter referred to as the A-side film) was peeled off 15 mm in the long side direction from the film including the barrier film 100A and the sealant layer 150 (hereinafter referred to as the B-side film). The A-side film and the B-side film at the peeled portion were gripped, peeled at 180°, and pulled at a rate of 50 mm/min, and the average value of the tensile stress in the stable region was measured. When the pulling was started, the distance between gripping tools was set at 30 mm, and when the pulling was stopped, the distance between the gripping tools was set at 60 mm.

(Wetted Peeling after Retorting)

Meanwhile, for wetted peeling, water was dropped with a dropper onto the peel boundary between the A-side film and the B-side film (the boundary between the joint and the peeled part) of the test piece that had been peeled 15 mm as mentioned above, and then the peel strength was measured.

The normal peeling and wetted peeling before retorting were measured in the state of the laminate mentioned above in <Production of Laminate>, without filling with tap water or performing the retort treatment.

[Table 3]

| | Barrier film alone | | Before retorting | | After high retorting at 130°C for 60 min | | After retorting and Gelbo at 128°C for 16 min |
|---|---|---|---|---|---|---|---|
| | OTR | WVTR | OTR | WVTR | OTR | WVTR | OTR |
| Example 1 | 0.6 | 0.6 | 0.3 | 0.4 | 0.5 | 0.6 | 2.0 |
| Example 2 | 0.7 | 0.6 | 0.8 | 0.4 | 0.4 | 0.8 | 1.4 |
| Example 3 | 1.1 | 1.1 | 0.6 | 0.6 | 0.6 | 0.9 | 2.9 |
| Example 4 | 0.6 | 0.6 | 0.3 | 0.4 | 0.5 | 0.5 | 2.2 |
| Example 5 | 0.6 | 0.7 | 0.4 | 0.8 | 0.7 | 0.7 | 1.7 |
| Example 6 | 1.1 | 0.9 | 0.3 | 0.5 | 0.5 | 0.6 | 2.7 |
| Example 7 | 0.5 | 0.2 | 0.4 | 0.3 | 0.6 | 0.9 | 2.5 |
| Example 8 | 0.8 | 0.4 | 0.6 | 0.4 | 0.8 | 0.9 | 2.2 |
| Example 9 | 0.2 | 0.4 | 0.2 | 0.3 | 0.2 | 0.5 | 2.8 |
| Example 10 | 0.5 | 0.4 | 0.6 | 0.3 | 0.4 | 0.5 | 2.3 |
| Example 11 | 0.2 | 0.3 | 0.6 | 0.3 | 0.4 | 0.5 | 2.2 |
| Example 12 | 0.3 | 0.5 | 0.4 | 0.4 | 0.5 | 0.5 | 1.9 |
| Example 13 | 0.4 | 0.6 | 0.3 | 0.5 | 0.6 | 0.5 | 2.1 |
| Example 14 | 0.5 | 0.7 | 0.4 | 0.5 | 1.5 | 0.8 | 1.5 |
| Example 15 | 0.4 | 0.7 | 0.4 | 0.6 | 1.1 | 0.7 | 1.3 |
| Example 16 | 0.8 | 0.9 | 0.3 | 0.4 | 0.5 | 0.7 | 2.4 |
| Example 17 | 0.5 | 0.8 | 0.3 | 0.4 | 0.3 | 0.6 | 1.7 |
| Example 18 | 0.2 | 0.4 | 0.2 | 0.3 | 0.2 | 0.3 | 0.9 |
| Comparative Example 1 | 0.5 | 0.5 | 0.5 | 0.3 | 1.0 | 2.0 | 1.9 |
| Comparative Example 2 | 0.9 | 1.8 | - | - | 1.0 | 2.1 | - |
| Comparative Example 3 | More than 100 | 6.7 | - | - | More than 100 | 2.1 | - |
| Comparative Example 4 | 0.2 | 1.0 | 0.5 | 1.2 | 21.0 | 2.1 | 3.9 |
| Comparative Example 5 | 4.5 | 2.0 | - | - | 13.1 | 1.3 | - |

[Table 4]

| | Adhesive strength before retorting (Normal/Wetted peeling) [N/15mm] | Adhesive strength after retorting at 128°C for 16 minutes (Normal/Wetted peeling) [N/15mm] |
|---|---|---|
| Example 1 | 3.4/2.9 | 2.9/2.9 |
| Example 2 | 3.3/3.4 | 3.4/3.4 |
| Example 3 | 3.2/3.2 | 2.9/2.9 |
| Example 4 | 3.4/3.6 | 3.6/3.6 |
| Example 5 | 3.3/3.2 | 3.2/3.2 |
| Example 6 | 3.4/2.9 | 2.9/2.9 |

(continued)

| | Adhesive strength before retorting (Normal/Wetted peeling) [N/15mm] | Adhesive strength after retorting at 128°C for 16 minutes (Normal/Wetted peeling) [N/15mm] |
|---|---|---|
| Example 7 | 3.0/3.0 | 3.0/3.0 |
| Example 8 | 3.5/3.5 | 3.5/3.4 |
| Example 9 | 3.0/3.0 | 3.0/2.4 |
| Example 10 | 3.3/3.3 | 3.2/3.2 |
| Example 11 | 3.4/3.4 | 3.0/3.0 |
| Example 12 | 2.5/1.0 | 2.5/0.2 |
| Example 13 | 2.0/2.0 | 2.0/2.0 |
| Example 14 | 2.8/2.7 | 2.7/2.3 |
| Example 15 | 2.7/2.7 | 2.6/2.5 |
| Example 16 | 3.0/3.0 | 3.1/3.1 |
| Example 17 | 3.0/3.0 | 3.4/3.4 |
| Example 18 | 2.4/2.4 | 5.0/2.0 |
| Comparative Example 1 | 3.1/2.6 | 4.0/4.0 |
| Comparative Example 2 | - | - |
| Comparative Example 3 | - | - |
| Comparative Example 4 | 3.0/3.0 | 4.3/2.3 |
| Comparative Example 5 | - | - |

From Tables 2 to 4, it can be seen that laminates using barrier films including polypropylene base materials according to the present embodiment, in which the intensity ratio P1 obtained from the XAFS spectrum is 0.37 or more and 0.78 or less, or P2 is 0.45 or more and 0.88 or less, have high barrier properties after the retort treatment and are excellent in Gelbo flex resistance and adhesion, even when a covering layer is not formed.

EXPLANATION OF REFERENCE NUMERALS

100:    Base material (polypropylene base material in the present invention)
110:    Polypropylene layer
115:    Base layer
120:    Deposition film
140:    Second polypropylene base material
150:    Sealant layer
161:    First adhesive layer
162:    Second adhesive layer
200,    300: Laminate
100A:    Barrier film

**Claims**

1.  A barrier film comprising a polypropylene base material provided with a base layer as an outermost layer, and a silicon oxide deposition film formed on the base layer, laminated in this order, wherein
    the silicon oxide deposition film has an intensity ratio P1 of 0.37 or more and 0.78 or less defined by the following equation when X-ray absorption fine structure analysis is performed from a surface opposite to the polypropylene base material side of the barrier film, P1 = (maximum intensity value from 1843.8 to 1845.2 eV)/(maximum intensity value from 1847.0 to 1849.4 eV).

2. A barrier film comprising a polypropylene base material provided with a base layer as an outermost layer, and a silicon oxide deposition film formed on the base layer, laminated in this order, wherein
the silicon oxide deposition film has an intensity ratio P2 of 0.45 or more and 0.88 or less defined by the following equation when X-ray absorption fine structure analysis is performed from a surface opposite to the polypropylene base material side of the barrier film, P2 = (maximum intensity value from 1845.4 to 1846.4 eV)/(maximum intensity value from 1847.0 to 1849.4 eV).

3. The barrier film according to claim 1 or 2, wherein the base layer comprises a polyamide resin.

4. The barrier film according to claim 1 or 2, wherein the polypropylene base material comprises at least the base layer and a first layer in this order, and
the first layer contains homopolypropylene.

5. The barrier film according to claim 1 or 2, wherein the polypropylene base material comprises at least the base layer, a first layer and a second layer in this order,

the first layer contains modified polypropylene, and
the second layer contains homopolypropylene.

6. The barrier film according to claim 5, wherein the polypropylene base material comprises at least the base layer, a first layer, a second layer, and a third layer in this order,

the first layer contains modified polypropylene,
the second layer contains homopolypropylene, and
the third layer contains a copolymer of propylene and olefin other than propylene.

7. The barrier film according to claim 3, comprising, as the polyamide resin, an amorphous aromatic polyamide alone, or a mixture of 50% by mass or more and less than 100% by mass of an amorphous aromatic polyamide and more than 0% by mass and less than 50% by mass of a crystalline aromatic polyamide.

8. The barrier film according to claim 1 or 2, wherein a covering layer is laminated on the silicon oxide deposition film.

9. A laminate comprising the barrier film according to claim 1 or 2 and a sealant layer.

10. A packaging bag comprising the laminate according to claim 9.

11. A method for producing a barrier film comprising a polypropylene base material provided with a base layer as an outermost layer, and a silicon oxide deposition film formed on the base layer, laminated in this order, wherein

the silicon oxide deposition film has an intensity ratio P1 of 0.37 or more and 0.78 or less, or P2 of 0.45 or more and 0.88 or less defined by the following equation when X-ray absorption fine structure analysis is performed from a surface opposite to the polypropylene base material side of the barrier film, and wherein
the silicon oxide deposition film is a deposition film formed by physical vapor deposition (PVD), P1 = (maximum intensity value from 1843.8 to 1845.2 eV)/(maximum intensity value from 1847.0 to 1849.4 eV) P2 = (maximum intensity value from 1845.4 to 1846.4 eV)/(maximum intensity value from 1847.0 to 1849.4 eV).

# FIG. 1

<u>100A</u>

# FIG. 2

200

140
162
120
115
100A
110
161
150

# FIG. 3

300

EP 4 782 207 A1

FIG. 4

XAFS spectrum(Si)

# FIG. 5

XAFS spectrum(Si)

EP 4 782 207 A1

# FIG. 6

XAFS spectrum(Si)

--- Example3

Intensity[arb.units]

Energy[eV]

# FIG. 7

XAFS spectrum(Si)

EP 4 782 207 A1

FIG. 8

XAFS spectrum(Si)

Example8

EP 4 782 207 A1

# FIG. 9

XAFS spectrum(Si)

FIG. 10

XAFS spectrum(Si)

EP 4 782 207 A1

## FIG. 11

XAFS spectrum(Si)

FIG. 12

## INTERNATIONAL SEARCH REPORT

| International application No. |
| --- |
| **PCT/JP2025/023436** |

| A. | CLASSIFICATION OF SUBJECT MATTER |
| --- | --- |

*B32B 27/32*(2006.01)i; *B32B 9/00*(2006.01)i; *B32B 27/34*(2006.01)i; *B65D 65/40*(2006.01)i; *C23C 14/08*(2006.01)i
FI:  B32B27/32 D; B32B9/00 A; B32B27/32 E; B32B27/34; B65D65/40 D; C23C14/08

According to International Patent Classification (IPC) or to both national classification and IPC

| B. | FIELDS SEARCHED |
| --- | --- |

Minimum documentation searched (classification system followed by classification symbols)

B32B27/32; B32B9/00; B32B27/34; B65D65/40; C23C14/08

Documentation searched other than minimum documentation to the extent that such documents are included in the fields searched

Published examined utility model applications of Japan 1922-1996
Published unexamined utility model applications of Japan 1971-2025
Registered utility model specifications of Japan 1996-2025
Published registered utility model applications of Japan 1994-2025

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| A | JP 2002-307600 A (DAI NIPPON PRINTING CO., LTD.) 23 October 2002 (2002-10-23) entire text, for example, examples | 1-11 |
| A | JP 2001-301109 A (DAI NIPPON PRINTING CO., LTD.) 30 October 2001 (2001-10-30) entire text, for example, examples | 1-11 |
| A | WO 2019/145108 A1 (TETRA LAVAL HOLDINGS & FINANCE S.A.) 01 August 2019 (2019-08-01) whole document, for example, examples | 1-11 |
| A | WO 2024/070759 A1 (DAI NIPPON PRINTING CO., LTD.) 04 April 2024 (2024-04-04) entire text, for example, examples | 1-11 |

☐ Further documents are listed in the continuation of Box C.  ☑ See patent family annex.

| | | |
| --- | --- | --- |
| * | Special categories of cited documents: | |
| "A" | document defining the general state of the art which is not considered to be of particular relevance | "T" later document published after the international filing date or priority date and not in conflict with the application but cited to understand the principle or theory underlying the invention |
| "D" | document cited by the applicant in the international application | "X" document of particular relevance; the claimed invention cannot be considered novel or cannot be considered to involve an inventive step when the document is taken alone |
| "E" | earlier application or patent but published on or after the international filing date | |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
| --- | --- |
| **19 August 2025** | **02 September 2025** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

**INTERNATIONAL SEARCH REPORT**
Information on patent family members

International application No.

**PCT/JP2025/023436**

| Patent document cited in search report | | | Publication date (day/month/year) | Patent family member(s) | | | Publication date (day/month/year) |
|---|---|---|---|---|---|---|---|
| JP | 2002-307600 | A | 23 October 2002 | (Family: none) | | | |
| JP | 2001-301109 | A | 30 October 2001 | (Family: none) | | | |
| WO | 2019/145108 | A1 | 01 August 2019 | EP | 3517291 | A1 | |
| | | | | CN | 111655474 | A | |
| WO | 2024/070759 | A1 | 04 April 2024 | TW | 202421438 | A | |
| | | | | JP | 2024-48327 | A | |

Form PCT/ISA/210 (patent family annex) (July 2022)

**REFERENCES CITED IN THE DESCRIPTION**

**Patent documents cited in the description**

- JP 7355957 B
- JP 6902231 B
- JP 2011214089 A
- WO 2019087960 A